(19) Europäisches Patentamt
European Patent Office
Office européen des brevets

(11) **EP 0 241 316 B1**

(12) **EUROPEAN PATENT SPECIFICATION**

(45) Date of publication and mention
of the grant of the patent:
**22.07.1998 Bulletin 1998/30**

(51) Int Cl.⁶: **H01L 21/205**, C23C 16/24

(21) Application number: **87303224.7**

(22) Date of filing: **13.04.1987**

(54) **Method for forming crystalline deposited film**

Verfahren zur Herstellung einer niedergeschlagenen kristalliner Schicht

Procédé pour former une couche déposée cristalline

(84) Designated Contracting States:
**AT BE CH DE ES FR GB GR IT LI LU NL SE**

(30) Priority: **11.04.1986 JP 83930/86**
**06.04.1987 JP 85516/87**

(43) Date of publication of application:
**14.10.1987 Bulletin 1987/42**

(73) Proprietor: **CANON KABUSHIKI KAISHA**
**Tokyo (JP)**

(72) Inventor: **Hirai, Yutaka**
**Hikone-shi Siga-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
DE-A- 3 525 211          DE-B- 2 151 346
GB-A- 2 087 930          US-A- 3 620 833
US-A- 4 443 488          US-A- 4 592 792

- JOURNAL OF THE ELECTROCHEMICAL
  SOCIETY, vol. 130, no. 7, July 1983, pages
  1571-1580, Manchester, US; L.JASTRZEBSKI et
  al.: "Growth process of silicon over SiO2 by
  CVD: Epitaxial lateral overgrowth technique"
- IBM TECHNICAL DISCLOSURE BULLETIN, vol.
  16, no. 9, February 1974, page 2871, New York,
  US; A.K. GAIND et al:: "Doped polysilicon
  isolation process"
- PHILIPS TECHNICAL REVIEW, vol. 41, no. 2,
  1983/84, pages 60-69, Einhoven, NL; J. BLOEM
  et al.: "Nucleation and growth of silicon films by
  chemical vapour deposition"
- JOURNAL OF THE ELECTROCHEMICAL
  SOCIETY, vol. 129, no. 10, October 1982, pages
  2303-2306, Manchester, US; D.D. RATHMAN et
  al.: "Lateral epitaxial overgrowth of silicon on
  SiO2"
- British Journal of Applied Physics, vol. 18, no.
  10, October 1967, pages 1357-1382

## Description

This invention relates to a method for forming a crystalline silicon deposited film, particularly to a method for forming a crystalline silicon deposited film controlled in grain size and prepared by utilising the difference in nucleation density of silicon according to the kinds of the deposition surface materials.

The present invention is applicable for formation of a crystalline silicon deposited film to be used for electronic devices, optical devices, magnetic devices, piezoelectric devices or surface acoustic devices, etc., such as semiconductor integrated circuits, optical integrated circuits, magnetic circuits, etc.

In the prior art, single crystal thin films to be used for semiconductor electronic devices or optical devices have been formed by epitaxial growth on a single crystal substrate. For example, it has been known that epitaxial growth of Si, Ge, GaAs, etc., can be done from liquid phase, gas phase or solid phase on Si single crystal substrate (silicon wafer), and it has been also known that epitaxial growth of a single crystal such as GaAs, GaAlAs, etc., occurs on a GaAs single crystal substrate. By use of the semiconductor thin film thus formed, semiconductor devices and integrated circuits, electroluminescent devices such as semiconductor lasers or LED have been prepared.

Also, researches and developments have been recently made abundantly about ultra-high speed transistors by use of two-dimensional electronic gas, ultra-lattice devices utilizing quantum well etc., and what has made these possible is the high precision epitaxial technique such as MBE (molecular beam epitaxy) or MOCVD (organometallic chemical vapor deposition) by use of ultra-high vacuum.

In such epitaxial growth on a single crystal substrate, it is necessary to take matching in lattice constants and coefficient of thermal expansion between the single crystal material of the substrate and the epitaxial growth layer. For example, although it is possible to effect epitaxial growth of Si single crystal thin film on sapphire which is a insulating single crystal substrate, the crystal lattice defect at the interface due to deviation in lattice constant and diffusion of aluminum which is a component of sapphire to the epitaxial layer pose problems in application for electronic devices or circuits.

Thus, the method for forming a single crystal thin film of the prior art by epitaxial growth may be understood to be dependent greatly on its substrate material. Mathews et al have examined about combinations of the substrate material with epitaxial growth layer (EPITAXIAL GROWTH, Academic Press, New York, 1975, ed. by J.W. Mathews).

Also, the size of the substrate is presently about 6 inches for Si wafer, and enlargement of GaAs, sapphire substrate is further retarded. In addition, since the single crystal substrate is high in production cost, the cost per chip becomes higher.

Thus, for production of a single crystal layer capable of preparing a device of good quality according to the method of prior art, there has been involved the problem the kinds of the substrate materials are limited to an extremely narrow scope.

On the other hand, researches and developments of three-dimensional integrated circuits to accomplish high integration and multi-function by laminating semiconductor devices in the normal line direction of the substrate have been abundantly made in recent years, and also researches and developments of large area semiconductor devices such as solar batteries or switching transistors of liquid crystal picture elements, etc., in which devices are arranged in an array on a cheap glass are becoming more abundant from year to year.

What is common to both of these is that the technique for forming a semiconductor thin film on an amorphous insulating material and forming an electronic device such as transistor, etc., thereon is required. Among them, particularly the technique for forming a single crystal semiconductor of high quality on an amorphous insulating material has been desired.

Generally speaking, when a thin film is deposited on an amorphous insulating material substrate such as $SiO_2$, etc., due to the defect of long distance order of the substrate material, the crystal structure of the deposited film becomes amorphous or polycrystalline. Here, the amorphous film refers to a state in which near distance order to the extent of the closest atoms is preserved, but no longer distance order exists, while the polycrystalline film refers to single crystal grains having no specific crystal direction gathered as separated at the grain boundaries.

For example, in the case of forming Si on $SiO_2$ according to the CVD method, if the deposition temperature is about 600 °C or lower, it becomes an amorphous silicon, while it becomes a polycrystalline silicon with grain sizes distributed between some ten to some hundred nm (some hundred to some thousand Å) at a temperature higher than said temperature. However, the grain sizes and their distribution of polycrystalline silicon will be varied greatly depending on the formation method.

Further, by melting and solidifying an amorphous or polycrystalline film by an energy beam such as laser or rod-shaped heater, etc., a polycrystalline thin film with great grain sizes of some microns or millimeters have been obtained (Single Crystal silicon on non-single-crystal insulator, Journal of crystal Growth vol, 63, No. 3, Octover, 1983 edited by G.W. Cullen).

When a transistor is formed on the thus formed thin film of respective crystal structures and electron mobility is measured from its characteristics, mobility of about 0.1 $cm^2/V \cdot sec$ or less is obtained for amorphous silicon, mobility of 1 to 10 cm$^2$/V · sec for polycrystalline silicon having grain sizes of some ten nm (some hundred Å), and a mobility to the same extent as in the case of single crystalline silicon for polycrystalline silicon with great grain sizes by melting and solidification.

From these results, it can be understood that there is great difference in electrical properties between the device formed in the single crystal region within the crystal grains and the device formed as bridging across the grain boundary. In other words, the deposited film on the amorphous material obtained in the prior art becomes amorphous or polycrystalline structure having grain size distribution, and the device prepared thereon is greatly inferior in its performance as compared with the device prepared on the single crystal layer. For this reason, the uses are limited to simple switching devices, solar batteries, photoelectric converting devices, etc.

On the other hand, the method for forming a polycrystalline thin film with great grain sizes by melting and solidification had the problems that an enormous time is required due to scanning of amorphous or single crystal thin film with energy beam for every wafer to be poor in bulk productivity, and also that it is not suited for enlargement of area.

US-A-3 620 833 discloses a method of depositing semiconductor single crystals on a substrate comprising a layer of insulating material, such as silicon dioxide, provided with nucleation sites, wherein the substrate is subjecte to a semiconductor (e.g. silicon) process which results in the formation of semiconductor single crystals at the nucleation sites. Hovewer, this document does not disclose sufficient details for implementing the process.

Further, in recent years, studies of diamond thin film growth are becoming popular. Diamond thin film, which is particularly broad in bandgap as 5.5 eV as the semiconductor, can be actuated at higher temperature (about 500 °C or less) as compared with Si, Ge, GaAs, etc., which are semiconductor materials of the prior art. Also, the carrier mobility of both electrons and positive holes surpass that of Si (1800 cm$^2$/V · sec for electrons, 1600 cm$^2$/V · sec for positive holes), and thermal conductivity is also extremely high. For this reason, it has been expected to be promising for application in semiconductor devices of the great consumption power type with great heat generation quantity.

However, although there have been reports in the prior art about epitaxial growth of diamond thin film on a diamond substrate by vapor phase growth (N. Fujimoto, T. Imai and A. doi Pro. of Int. couf. IPAT), there is no successful report about heteroepitaxial growth on a substrate other than diamond substrate.

Generally speaking, diamond nuclei are generated by utilizing excitation with microwave, using a hydrocarbon type gas such as $CH_4$, etc., and by irradiation with hot filament or electron beam, but the nucleation density is generally low, whereby a continuous thin film can be obtained with difficulty. Even if a continuous thin film may be formed, it has a polycrystalline structure with great grain size distribution and can be difficultly applied for semiconductor device.

Also, as long as a diamond substrate is used, it is expensive as a matter of course, posing also a problem in enlargement of area. Thus, it is not suitable for practical application.

As described above, in the crystal growth method of the prior art and the crystal formed thereby, three-dimensional integration or enlargement of area could not be done with ease to be difficultly applied practically for devices, and crystals such as single crystals and polycrystals, etc., required for preparation of devices having excellent characteristics could not be formed easily and at low cost.

On the other hand, hitherto, for formation of functional films, particularly crystalline semiconductor films, suitable film forming methods have been individually employed from the standpoint of desired physical characteristics, uses, etc.

For example, for formation of silicon deposited films such as of amorphous or polycrystalline, i.e. non-single crystalline, silicon which are optionally compensated for lone pair electrons with a compensating agent such as hydrogen atoms (H) or halogen atoms(X), etc., (hereinafter abbreviated as "NON-Si (H,X)", particularly "A-Si (H,X)" when indicating amorphous silicon and "poly-Si (H,X)" when indicating polycrystalline silicon) (the so-called microcrystalline silicon is included within the category of A-Si (H,X) as a matter of course), there have been employed the vacuum vapor deposition method, the plasma CVD method, the thermal CVD method, the reactive sputtering method, the ion plating method, the optical CVD method, etc. Generally, the plasma CVD method has been widely used and industrialized.

However, the reaction process in formation of a silicon deposited film according to the plasma CVD method which has been generalized in the prior art is considerably complicated as compared with the conventional CVD method, and its reaction mechanism involves not a few unclarified points. Also, there exist a large number of parameters for formation of a deposited film such as substrate temperature, flow rate and flow rate ratio of gases to be introduced, pressure during formation, high frequency power, electrode structure, structure of a reaction vessel, speed of evacuation, plasma generating system, etc. By use of a combination of such a large number of parameters, plasma may sometimes become unstable state, whereby marked deleterious influences were exerted frequently on a deposited film formed. Besides, parameters characteristic of film forming devices must be selected for each device and therefore under the present situation it has been difficult to generalize the production condition.

Also, in the case of the plasma CVD method, since plasma is directly generated by high frequency or microwave, etc., in a film forming space in which a substrate on which film is to be formed is placed, electrons or a number of ion species generated thereby may give damages to the film in the film forming process to cause lowering in film quality or non-uniformization of film quality. Moreover, the condition suitable for crystallization of a deposited film is restricted and therefore it has been deemed to be difficult to produce a polycrystalline deposited film with stable characteristics.

On the other hand, for formation of an epitaxial deposited film such as of silicon, germanium, group II-VI or Group III-V semiconductors, etc., there have been used the gas phase epitaxy and the liquid phase epitaxy as defined in a broad sense (generally speaking, the strict definition of epitaxy is to grow another single crystal on a single crystal, both having the same single crystal axes, but, in the terms "gas phase epitaxy" and "liquid phase epitaxy", "epitaxy" is used in a broader sense and it is not limited to the growth onto a single crystal substrate).

The liquid phase epitaxy is a method for precipitating a semiconductor crystal on a substrate by dissolving a starting material for semiconductor at high temperature to a super-saturated state in a solvent metal which is molten to a liquid and cooling the solution. According to this method, since crystals are grown under a state most approximate to thermal equilibrium among various epitaxy techniques, crystals with high perfectness can be obtained, but on the other hand, bulk productivity is poor and surface state is bad. For such reason, in an optical device which requires an epitaxial layer which is thin and also uniform in thickness, problems are accompanied such as yield in device production, or influences exerted on device characteristics, etc., and therefore this method is not frequently used.

On the other hand, the gas phase epitaxy has been attempted by physical methods such as the vacuum vapor deposition method, the sputtering method, etc., or chemical methods such as hydrogen reduction of a metal chloride or otherwise thermal pyrolysis of a metal organic compound or a metal hydride. Among them, the molecular beam epitaxy which is a kind of the vacuum vapor deposition method is a dry process under ultra-high vacuum, and therefore high purification and low temperature growth of crystals are possible, whereby there is the advantage that comoposition and concentration can be well controlled to give a relatively flat deposited film. However, in addition to an enormous cost required for a film forming device, the surface defect density is great, and no effective method for controlling directionality of molecular beam has been developed, and also enlargement of area is difficult and bulk productivity is not so high. Due to such many problems, it has not been industrialized yet.

The hydrogen reduction method of a metal chloride or the thermal pyrolysis method of a metal organic compound or a metal hydride are generally called the halide CVD method, the hydride CVD method, MO-CVD method. for these methods, by the reason that a film forming device can be made with relative ease and also as the starting materials, i.e. metal chloride, metal hydrides and organic metals, those with high purities are now readily available, they have studied widely at the present time and application for various devices has been investigated.

However, in these methods, it is required to heat a substrate to a high temperature at which reduction reaction or thermal pyrolysis reaction can occur and therefore the scope of substrate material to be selected is limited, and also contamination with impurities such as carbon or halogen, etc., is liable to cause if decomposition of starting material is insufficient, thus having the drawback that controllability of doping is poor. Also while, depending on the application use of a deposited film, it is desired to effect bulk production with reproducibility with full satisfaction in terms of enlargement of area, uniformization of film thickness as well as uniformness of film quality and yet at a high speed film formation, under the present situation no technique which enables bulk production with maintaining practical characteristics satisfying the above demands has been established yet.

There is described in a paper entitled "Growth Process of Silicon Over SiO$_2$ by CVD Epitaxial Lateral Overgrowth Technique", J. Electrochem, Soc., 130, (1983), pp. 1571-80, a process of epitaxial lateral overgrowth. A halogenic compound gas hydrogen chloride is introduced as one of the CVD gaseous components. The process is one in which epitaxial growth proceeds from a lattice constant matched single crystal surface.

In Philips Techn. Rev., 41 (1983/84), pp 60-69, a number of processes are described by which means silicon is deposited onto an amorphous surface of either silicon oxide or alternatively silicon nitride. A compound containing both silicon and a halogen as one of the CVD reagents is disclosed. Chlorosilanes are passed over a hot substrate and either hydrogen or nitrogen is used as a carrier and hydrogen chloride gas can be added as an etchant. This process requires the provision of a hot substrate and it is the heat from this substrate which provides the necessary activation that precedes the decomposition of the chlorosilane reagent.

DE-A-3525211 discloses a method of depositing amorphous silicon in which reagent gases are activated in separate chambers before introduction into the reaction chamber.

The present invention, as defined by the appended claims, is intended to overcome the problems of the prior art as described above.

A particular feature of the method defined is that the gas vapour components used to deposit silicon, specifically a chain or cyclic silane compound of which hydrogen atoms are partially or wholly substituted with halogen atoms and one or both of hydrogen gas and halogen gas are activated in separate chambers prior to being brought into the reaction chamber where silicon is to be deposited on the substrate.

Embodiments of the present invention provide a method for forming a polycrystalline silicon film controlled in grain boundary position, etc., without restriction with respect to the base materials, for example, without restriction with respect to materials, constitutions, sizes, etc., of the substrate.

Embodiments of the present invention also provide a method for forming the above film with good efficiency according to simple steps without use of a special device.

Embodiments of the present invention provide a method for forming a deposited film which is easy in control of film quality simultaneously with saving energy and can give a crystalline deposited film having desired characteristics uniformly over a large area and excellent in semiconductive characteristics.

Embodiments of the present invention provide a method for forming a deposited film which is excellent in productivity and bulk productivity and can form simply and efficiently a crystalline silicon deposited film having high quality and excellent physical characteristics such as electrical, optical or semiconductive characteristics, etc.

The method for forming a deposited film of the present invention has a specific advantage in forming a deposited film by use of active species without utilising plasma reaction since the plasma CVD method of the prior art forms plasma discharging by permitting discharging energy, etc., to act on starting gases for formation of a deposited film. The present method is not subject to any bad influence by etching or abnormal discharging, etc., during film formation.

Also, since the method for forming a deposited film of the present invention utilises the reaction of an active species (A) obtained by activating a chain or cyclic silane compound (SX) of which hydrogen atoms are partially or wholly substituted with halogen atoms with an active species (B) formed from activating hydrogen gas, halogen gas or admixture thereof, it requires no high temperature for deposition, and therefore there is no disturbance of structure by heat, and no heating installation during production and no expense accompanied with running thereof are required, whereby a device can be made at a lower cost. It becomes possible to select the substrate material from a wide scope of materials without depending on heat resistance.

Also, use of a large deposition area is facilitated. The method is not restricted by the shape and the size of the substrate, and at the same time the starting materials employed may be very small in amounts, whereby the film forming space can be made smaller to improve the yield dramatically.

Also, the size and locations of the crystal grains can be determined by arranging the locations of the deposition surface areas as desired on the substrate.

It has now become possible to form a good crystalline deposited film having uniform film quality and characteristics over a large area with easy control of film quality simultaneously with energy saving in formation of deposited film. Further, a crystalline deposited film of high quality with excellent characteristics such as electrical, optical, semiconductor characteristics can be obtained efficiently with excellent productivity and bulk productivity.

In the accompanying drawings:

Fig. 1 is a graph for illustration of the relationship between the size of nucleus rc and free energy G in the process of forming thin film;

Figs. 2(A) and 2(B) are illustrations of the selective deposition method;

Fig. 3 is a graph showing the change with lapse of time of nucleation density (ND) on a deposition surface of $SiO_2$ and a deposition surface of silicon nitride;

Figs. 4(A) to 4(D) are illustrations of the formation steps showing a first embodiment of the method for forming crystalline silicon film according to the present invention;

Figs. 5(A) and 5(B) are perspective views of the substrate in Figs. 4(A) and 4(D);

Figs. 6(A) to 6(D) are illustrations of the steps for forming film showing a second embodiment;

Figs. 7(A) to 7(C) are illustrations of the formation steps showing a third embodiment;

Figs. 8(A) and 8(B) are perspective views of the substrates in Figs. 7(A) and 7(C);

Figs. 9(A) to 9(C) are illustrations of the steps for forming film showing a fourth embodiment;

Figs. 10(A) to 10(C) are illustrations of formation steps showing a fifth embodiment;

Figs. 11(A) to 11(D) are illustrations of the formation steps of film showing a sixth embodiment;

Fig. 12 is a graph showing the relationship between the flow rate ratio of $SiH_4$ and $NH_3$ and the composition ratio of Si and N in the silicon nitride film formed;

Fig. 13 is a graph showing the relationship between Si/N composition ratio and nucleation density;

Fig. 14 is a graph showing the relationship between the injected amount of Si ions and nucleations density;

Figs. 15(A) to 15(D) are illustrations of the formation steps showing a seventh embodiment;

Figs. 16(A) and 16(B) are perspective views of the substrates in Figs. 15(A) and 15(D);

Figs. 17(A) to 17(C) are illustrations of the steps for forming crystal showing an eighth embodiment of the present invention;

Figs. 18(A) and 18(B) are perspective views of the substrates in Figs. 17(A) and 17(C);

Figs. 19(A) to 19(D) are illustrations of the formation steps of crystal showing a ninth embodiment of the present invention;

Fig. 20 is a schematic illustration of the film-forming device used in Examples of the present invention;

Figs. 21(A) to 21(F) are diagrams of film forming steps for performing the present invention;

Figs. 22(A) to 22(E) are diagrams of other film forming steps for performing the present invention;

Fig. 23 is a schematic sectional view showing an example of the deposited film obtained on a specific substrate; and

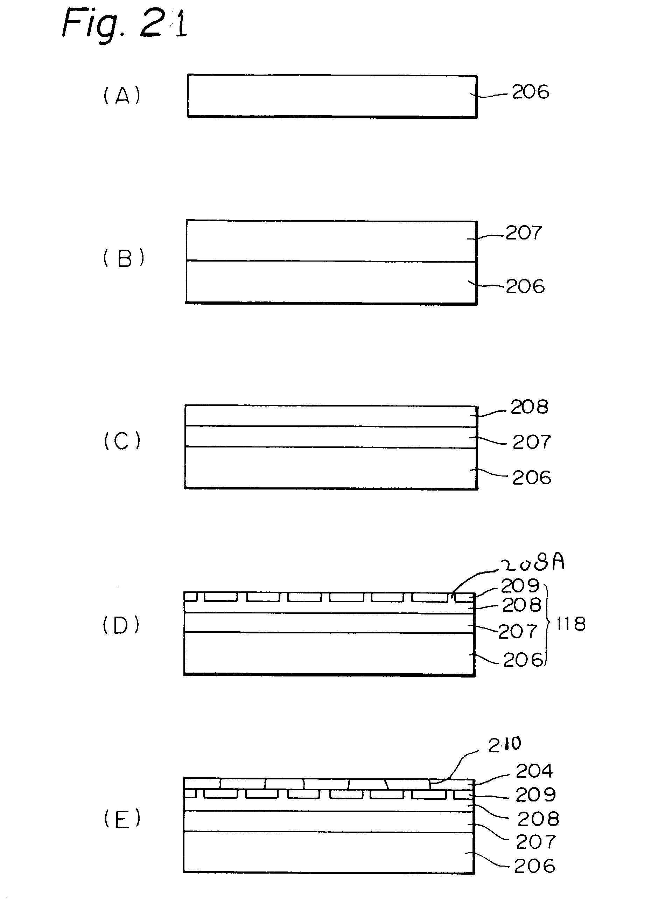

Fig. 24 is a schematic structural view of a T F T fabricated utilising a deposition film obtained by the present invention.

In the present invention, the activated species (A) from the activation space (A) should preferably be selected and used as desired from those having a lifetime of 0.1 sec. or longer, more preferably 1 sec. or longer, optimally 10 sec. or longer, from the standpoint of productivity and easiness in handling, and the constituent elements of the active species (A) become the components constituting the deposited film formed in the film forming space. Also, the hydrogen gas, halogen gas or admixture is activated to become the active species (B) by the action of an activation energy in the activation space (B) before introduction into the film forming space, and introduced from the activation space (A) at the same time during formation of the deposited film to undergo chemical mutual reaction with the active species (A) containing constituent elements which become the constituent components of the deposited film formed.

In the present invention as the compound containing silicon and halogen to be introduced into the activation space (A), there may be employed, for example the chain or cyclic silane compounds of which hydrogen atoms are partially or wholly substituted with halogen atoms, may be chosen from chain silicon halides represented by $Si_uY_{2u+2}$ (u is an interger of 1 or more, Y is at least one element selected from F, Cl, Br and I) and cyclic silicon halides $Si_vY_{2v}$ (v is an integer of 3 or more, and Y has the same meaning as defined above), chain and cyclic compounds represented by $Si_uH_xY_y$ (u and Y have the same meaning as defined above, $x + y = 2u$ or $2u + 2$).

Specific examples are gaseous or readily gasifiable compounds such as $SiF_4$, $(SiF_2)_5$, $(SiF_2)_6$, $(SiF_2)_4$, $Si_2F_6$, $Si_3F_8$, $SiHF_3$, $SiH_2F_2$, $SiCl_4$, $(SiCl_2)_5$, $SiBr_4$, $(SiBr_2)_5$, $Si_2Cl_6$, $Si_2Br_6$, $SiHCl_3$, $SiH_2Cl_2$, $SiH_3Cl$, $SiHBr_3$, $SiHI_3$, $Si_2Cl_3F_3$, and the like.

In the present invention, as the method for forming activated species (A) in the activation space (A), there may be employed various activation energies such as electrical energies, including microwave, RF, low frequency DC, etc., heat energies such as heater heating, IR-ray heating, etc., photoenergy, etc. in view of respective conditions and the device.

The halogen gas for forming active species (B) in the activation space (B), may be one of $F_2$ gas, $Cl_2$ gas, or gasified $Br_2$, or $I_2$. Also, an inert gas such as helium, argon, neon, etc., may be added. When a plural number of these chemical substances for film formation are employed, they can be mixed previously and introduced under gaseous state into the activation space (B), or alternatively these chemical substances for film formation may be fed individually from the respective independent feeding sources to be introduced into the activation space (B), or they can be introduced into the respective independent activation spaces to be individually activated.

In the present invention, the proportion in amount of the above activated species (A) to the activated species (B) to be introduced into the film forming space will depend on the depositing conditions, the kind of the activated species, etc., but may preferably be 10 : 1 to 1 : 10, more preferably 8 : 2 to 4 : 6.

Also, the deposited film formed according to the present invention can be doped with a dopant impurity element during or after film formation. As the impurity element to be used, there may be employed, as p-type impurity, an element belonging to the group IIIA of the periodic table such as B, Al, Ga, In, Tl, etc. and, as n-type impurity, an element belonging to the group VA of the periodic table such as N, P, As, Sb, Bi, etc. as suitable ones. Particularly, B, Ga, P and Sb are most preferred. The amount of the impurity to be doped will depend on the desired electrical and optical characteristics.

As the substance containing such an impurity atoms as the component (substance for introduction of impurity), it is preferable to select a compound which is gaseous under normal temperature and normal pressure, or gaseous at least under the conditions for formation of deposited film and can be readily gasified by a suitable gasifying device. Such compounds may include $PH_3$, $P_2H_4$, $PF_3$, $PF_5$, $PCl_3$, $AsH_3$, $AsF_3$, $AsF_5$, $AsCl_3$, $SbH_3$, $SbF_5$, $BiH_3$, $BF_3$, $BCl_3$, $BBr_3$, $B_2H_6$, $B_4H_{10}$, $B_5H_9$, $B_5H_{11}$, $B_6H_{10}$, $B_6H_{12}$, $AlCl_3$, etc. The compounds containing impurity element may be used either singly or as a combination of two or more compounds.

The substances for introduction of impurities may be directly introduced under gaseous state into the film forming space, or alternatively activated previously in the activation space (A) or the activation space (B) or a third activation space (C) before introduction into the film forming space.

On the other hand, a dependency of growth speed upon face direction has been found during crystal growth of silicon or silicon containing materials. This may differ depending on the deposited film forming method or deposition conditions, but in the method of the present invention, the preferential order has been found to be (110) > (111) > (100). By suitable selection of the kind of substance (E) for etching and etching condition under this condition, the condition with stronger orientability of (110) >> (111) >> (100) can be realized. It is realized in the present invention to strengthen the above orientability and accelerate the growth speed, particularly by setting a portion for accelerating nucleation on the substrate. And, not only formation of polycrystalline deposited film with great grain size oriented only toward the (110) face is possible, but it is also possible to grow a single crystal by selecting the size, shape, interval, material, etc., of the nucleus.

In the method of the present invention, for forming selectively a desired crystalline deposited film, it is necessary to arrange previously a material capable of forming selectively crystal nuclei in the form corresponding to the purpose regularly or irregularly scatteringly on the substrate surface.

By utilising the difference in nucleus formation density according to the kinds of the materials constituting the nucleation surfaces, by arranging the nucleation surfaces scatteringly with a desired pattern on the substrate, desired crystalline deposited film can be formed selectively.

As the substrate to be used for obtaining Si crystal in the present invention, for example, those having $Si_3N_4$ arranged scatteringly on $SiO_2$ film or those having $SiO_2$ covered over $Si_3N_4$ film to have partially the subbing $Si_3N_4$ exposed may be employed.

These substrates utilize the property of silicon crystal nuclei which are formed with ease on $Si_3N_4$ and with difficulty on $SiO_2$, and in the method for forming deposited film of the present invention, both amorphous and crystalline materials can be used, provided that they have difference in difficulty and easiness in formation of nuclei.

The substrate temperature (Ts) during film formation may be set suitably depending on the kind of the deposited film to be formed and the kind of the substrate used.

For better understanding of the present invention, the general process for forming a thin film of metal for semiconductor is explained.

When the deposition surface is made of a material different in kind from the flying atom, particularly an amorphous material, the flying atoms are diffused freely on the substrate surface, or again evaporated (released). And, as the result of collision mutually between the atoms, a nucleus is formed and when its size becomes the size rc ($= -2\sigma_o/gv$) at which its free energy G becomes the maximum (critical nucleus), G is reduced and the nucleus continues to grow stably three-dimensionally to become shaped in an island. The nucleus with the size exceeding rc is called "stable nucleus", and unless otherwise particularly noted, "nucleus" in the following basic description of the present invention refers to this "stable nucleus". Also, among "stable nucleus", those with small $\underline{r}$ are called "initial nucleus".

The free energy generated by formation of nucleus is represented as follows:

$$G = 4\pi f(\theta)(\sigma_o \, r^2 + 1/3 \cdot gv \cdot r^3)$$

$$f(\theta) = 1/4 \, (2 - 3\cos\theta + \cos^2 \theta)$$

wherein,

r : radius curvature of nucleus
$\theta$ : contact angle of nucleus
gv : free energy per unit deposition
$\sigma_o$ : surface energy between nuclius and vacuum.

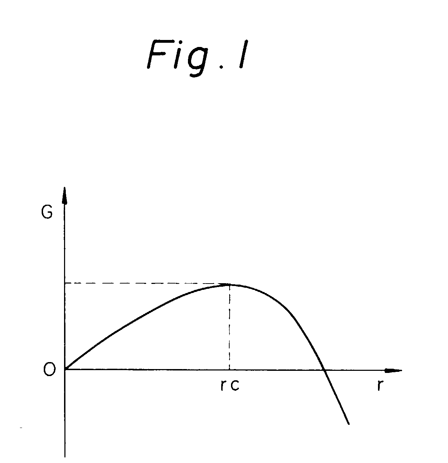

Fig. 1 shows the manner in which free energy G is changed. In the same Figure, the radius of curvature of the stable nucleus when free energy G is at the maximum value is rc.

Thus, nuclei grow to become shaped in islands, and further grow whereby contact mutually between islands progresses until sometimes coalescence occurs and via a network structure, it becomes finally a continuous film to cover completely over the substrate surface. Following such a process, a thin film is deposited on the substrate.

In the deposition process as described above, the density of nucleus formed per unit area of the substrate surface, the size of nucleus and the nucleation speed are determined depending on the state of the system of deposition, and particularly the interaction between the flying atoms and the substrate surface material is an important factor. Also, a specific crystal direction grows in parallel to the substrate due to anisotropy relative to the crystal surface of the interface energy at the interface between the deposited material and the substrate, and when the substrate is amorphous, the crystal direction within the substrate plane is not constant. For this reason, grain boundaries are formed by collision mutually between nuclei or islands, and particularly in the case of collision mutually between islands with some sizes or greater, grain boundaries are formed as such upon occurrence of coalescence. Since the grain boundaries formed do not move easily in the solid phase, the grain sizes are determined at that point.

Next, the selective deposition method for forming a deposited film selectively on the deposition surface is to be described. The selective deposition method is a method in which a thin film is formed selectively on the substrate by utilizing the differences between the materials in factors influencing nucleus formation in the thin film forming process such as surface energy, attachment coefficient, release coefficient, surface diffusion speed, etc.

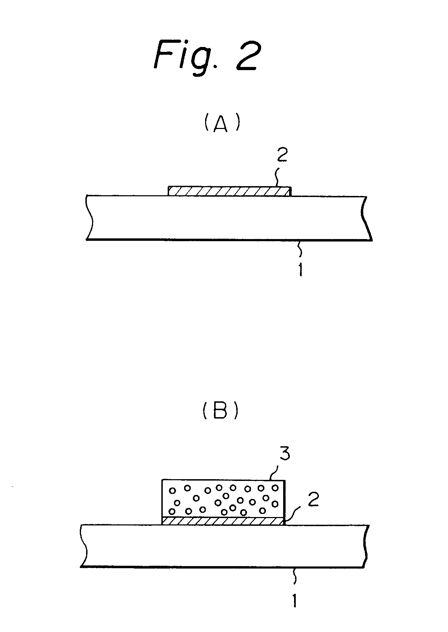

Figs. 2A and 2B are illustrations of the selective deposition method. First, as shown in Figure 2A, on the substrate 1, a thin film 2 comprising a material different in the above factors from the substrate 1 is formed at a desired portion. And, when deposition of a thin film comprising an appropriate material is effected under appropriate deposition conditions, a thin film 3 grows only on the thin film 2, whereby it is possible to give rise to a phenomenon that no growth occurs on the substrate 1. By utilizing this phenomenon, the thin film 3 formed self-matchingly can be grown, whereby it becomes possible to omit the lithographic step by use of a resist as practiced in the prior art.

As the material for enabling deposition of silicon thin film 2 according to such selective formation method, for example, $SiO_2$ may be used as the substrate 1, and Si, GaAs, silicon nitride as the thin film 2.

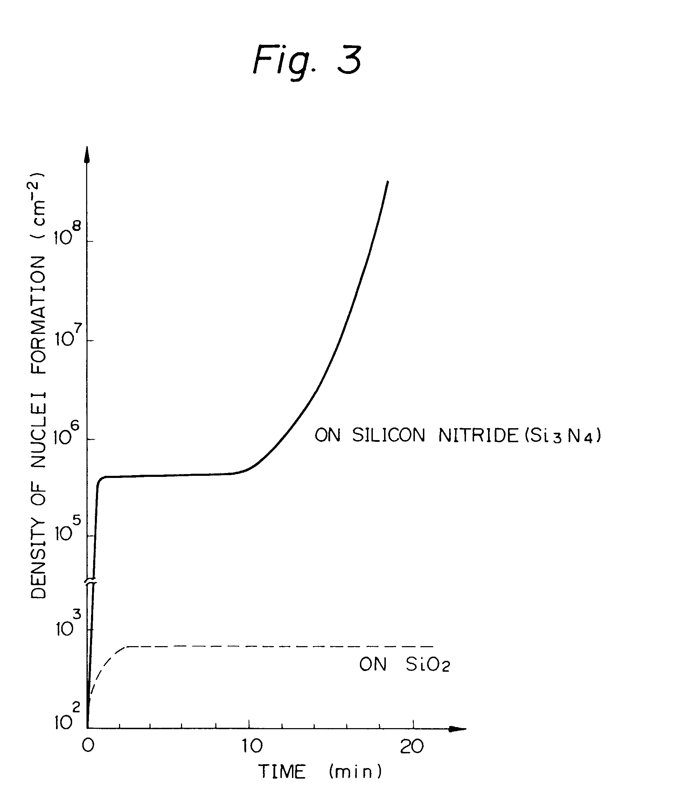

Fig. 3 is a graph showing the change with lapse of time of nucleation density (ND) on the deposited surface of $SiO_2$ and the deposited surface of silicon nitride.

As shown in the same graph, soon after initiation of deposition, the nucleation density (ND) on $SiO_2$ is saturated at $10^3$ cm$^{-2}$ or less, and the value is not substantially changed even after 20 minutes.

In contrast, on silicon nitride ($Si_3N_4$), it is once saturated at about $4 \times 10^5$ cm$^{-2}$ or less and not substantially changed for 10 minutes thereafter, but is abruptly increased thereafter. This measurement example shows the case in which $SiCl_4$ gas is diluted with $H_2$ and deposited according to theCVD method under the conditions of a pressure of $2.27 \times 10^4$ Pa (170 Torr) and a temperature of 1000°C.

Such a phenomenon depends greatly on the difference in adsorption coefficient, release coefficient, surface diffusion coefficient, etc., relative to Si of the material surfaces of $SiO_2$ and silicon nitride, but the fact that $SiO_2$ itself is etched by the reaction of $SiO_2$ with Si atom itself to form silicon monooxide with higher vapor pressure, while no such etching phenomenon occurs on silicon nitride may be also considered to be a cause to effect selective deposition (T. Yonehara, S. Yoshioka, S. Miyazawa, Journal of Applied Physics 53, 6839, (1982)).

Thus, by selecting $SiO_2$ and silicon nitride as the materials of the deposition surface and silicon as the material to be deposited, sufficiently great nucleation density difference (ΔND) as shown in the same graph can be obtained. Here, although $SiO_2$ is desirable as the material for the deposition surface, this is not limitative and sufficiently practical nucleation density difference (ΔND) can be obtained even by use of $SiO_x$ ($0 < x < 2$).

Of course, the present invention is not limited to these materials, but the difference in nucleation density (ΔND) may be sufficiently $10^3$-fold or more in density of nuclei as shown by the same graph, and sufficient selective formation of deposited film can be done with the materials as exemplified below.

As another method for obtaining this nucleation density difference (ND), ions of Si, N, etc., may be injected locally into the $SiO_2$ surface to form a region having excessive Si or N.

The present invention utilizes selective deposition based on such nucleation density difference (ΔND) and, by forming a sufficiently minute region of a different kind of material having sufficiently greater nucleation density than the material of the deposition surface, so that a single nucleus may grow on the region, a single crystal is to be grown selectively only at the site where such fine different kind of of material exists.

In this connection, since selective growth of a single crystal is determined depending on the electron state of the crystal formation surface, particularly the state of dangling bonds, the material with higher nucleation density (for example, $Si_3N_4$) is not required to be a bulk material, but it may also be formed as a thin film on the surface of base plate of any desired material to form the above crystal formation surface.

In the following, the present invention is described in detail by referring to the drawings.

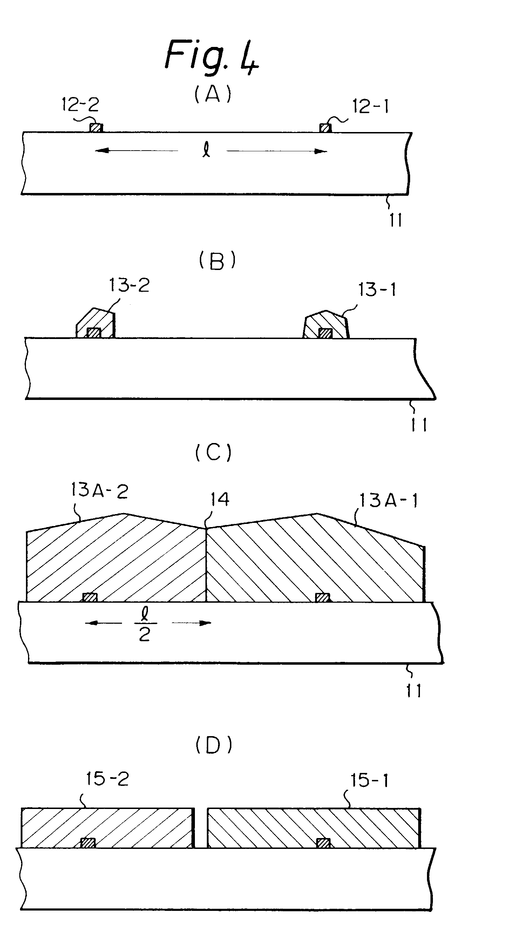

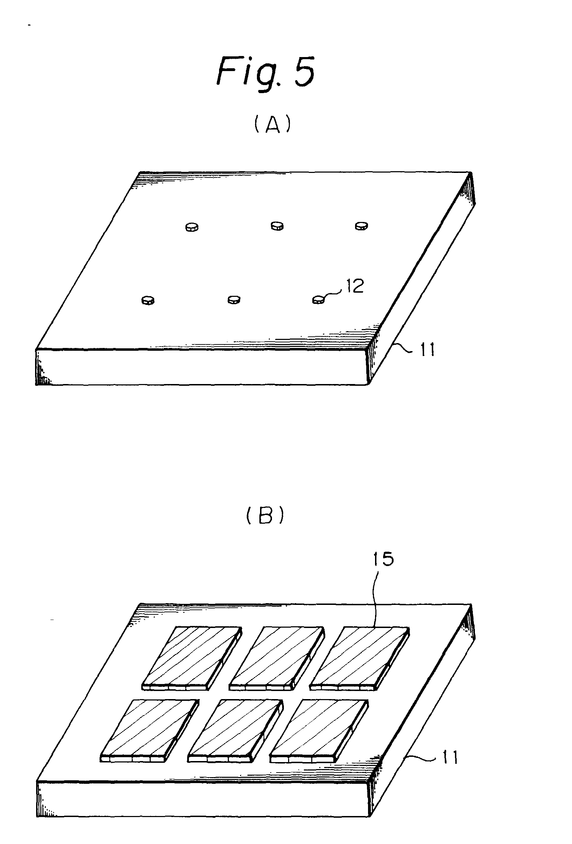

Figs. 4(A) - 4(D) are illustrations of the formation steps showing a first embodiment of the method for forming film according to the present invention, and Figs. 5(A) and 5(B) are perspective views corresponding to Figs. 4(A) and 4(D).

As shown in Fig.4 (A) and Fig.5,(A), on the amorphous insulating substrate 11, with an interval of a distance $\underline{\ell}$, nucleation surfaces ($S_{NDL}$) 12-1, 12-2, of a material different from the substrate 11 enabling the above selective nucleation are arranged sufficiently finely. The distance $\underline{\ell}$ is set equal to the size of the single crystal region required for formation of semiconductor device or group of devices or greater.

Next, by selecting appropriate crystal forming conditions, on the nucleation surfaces ($S_{NDL}$) 12-1, 12-2, only a nucleus of a crystal forming material is formed. That is, the nucleation surfaces 12-1, 12-2, are required to be formed to a sufficiently fine size (area) to the extent that only a single nucleus may be formed. The size of the nucleation surfaces ($S_{NDL}$) 12-1, 12-2, which may be different depending on the kind of the material, may be several microns or less. Further, the nucleus grows while maintaining the single crystal structure, and become island-shaped single crystal grains 13-1, 13-2, as shown in Fig. 4(B). For forming island-shaped single crystal grains 13-1, 13-2, it is desirable to determine the conditions so that substantially no nucleation may occur at all on other surfaces than the nucleation surfaces ($S_{NDL}$) on the substrate 11.

The crystal direction in the normal line direction of the substrate 11 of the island-shaped single crystal grains 13-1, 13-2 is determined so as to make the interface energy of the material of the substrate 11 and the material forming nucleus minimum. For, surface or interface energy has anisotropy depending on the crystal face. However, as already mentioned, the crystal direction within the substrate plane in amorphous substrate is not determined.

The island-shaped single crystal grains 13-1, 13-2 further grow to become single crystals 13A-1, 13A-2, until the adjacent single crystals 13A-1, 13A-2, contact each other as shown in Fig. 4(C), but since the crystal directions within the substrate plane are not constant, a crystal grain boundary 14 is formed at the intermediate position between the nucleation surfaces ($S_{NDL}$) 12-1 and 12-2.

Subsequently, the single crystals 13A-1, 13A-2 grow three-dimensionally, but crystal faces with slow growth speed appear as the facet. For this reason, the surfaces of single crystals 13A-1, 13A-2 are flattened by etching or polishing, and further the portion of the grain boundary 14 is removed to form thin films of single crystals 15-1, 15-2,... containing no grain boundary in shape of lattices as shown in Fig. 4(D) and Fig. 5(B). The size of the single crystal films 15-1, 15-2, ... is determined by the interval $\underline{1}$ between the nucleation surfaces ($S_{NDL}$) 12A-1, 12A-2, as described above. That is, by determining appropriately the formation pattern of the nucleation surface ($S_{NDL}$) 12A-1, 12A-2, the position of the grain boundary can be controlled to form single crystals with desired sizes at a desired arrangement.

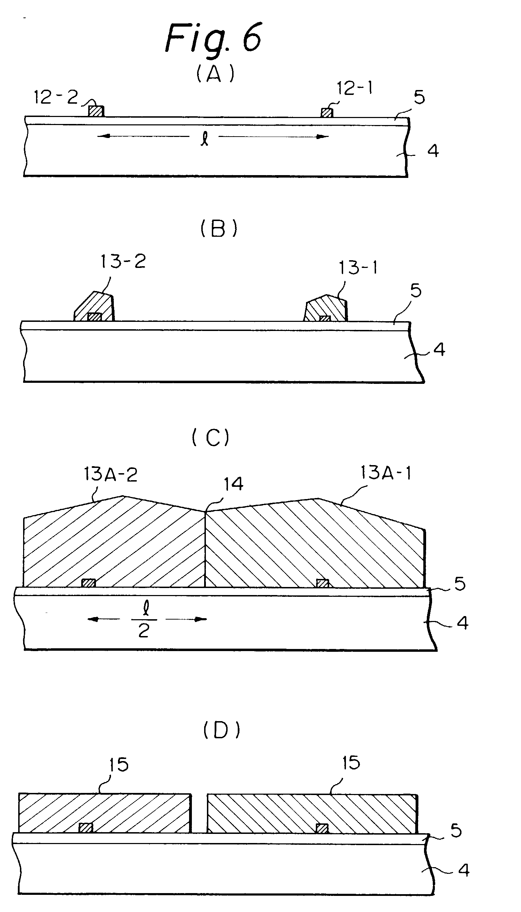

FIGS. 6(A)-6(D) are illustrations of the formation steps of crystal showing a second embodiment of the present invention. As shown in these Figures, on a desired substrate 4 is formed a thin film non-nucleation surface ($S_{NDS}$)5 comprising a material with small nucleation density (ND) enabling selective nucleation is formed, and nucleation surfaces ($S_{NDL}$)12 comprising a different kind of material with greater nucleation density (ND) are formed with an interval $\ell$ thereon, and a single crystal layer 15 can be formed in the same manner as in the above embodiment.

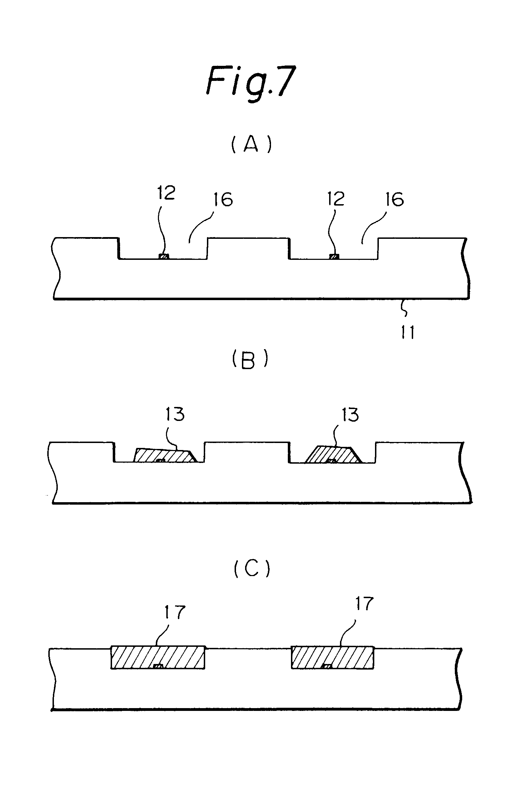

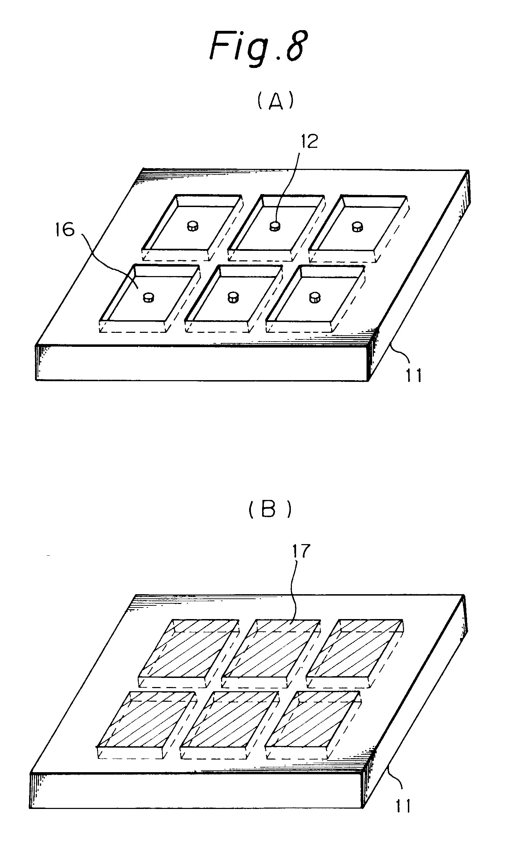

Figs. 7(A)-7(C) are illustrations of the formation steps showing a third embodiment of the present invention, and Figs. 8(A) and 8(B) are perspective views of the substrates in Figs. 7(A) and 7(C).

First, as shown in Fig. 7(A) and Fig. 8(A), recesses 16 with desired size and shape are formed on the amorphous insulating substrate 11, and nucleation surfaces ($S_{NDL}$) 12 with sufficiently fine size for forming only single nucleus are formed therein.

Subsequently, as shown in Fig. 7(B), island-shaped single crystal grains 13 are grown similarly as in the first embodiment.

And, as shown in Fig. 7(C) and Fig. 8(B), single crystal grains 13 are grown until embedding the recess 16 to form a single crystal 17.

In this embodiment, since single crystal grains 13 grow within the recess 16, the steps of flattening and removing the grain portion may be unnecessary.

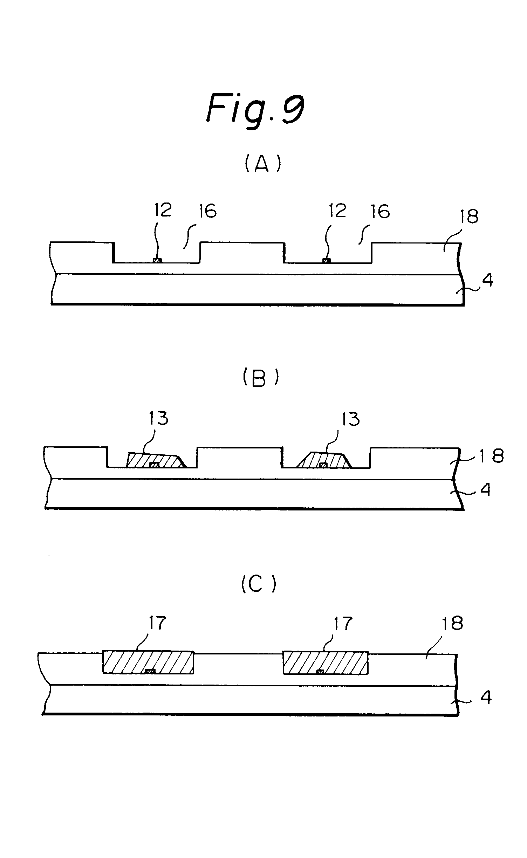

Figs. 9(A)-9(C) are illustrations of the formation steps of crystal showing a fourth embodiment of the present invention. As shown in these Figures, on any desired substrate 4 similarly as in the first embodiment, a thin film non-nucleation surface ($S_{NDS}$) 18 comprising a material with small nucleation density(ND) enabling selective nucleation is formed, and recesses 16 with desired size and shape are formed thereon. and, within the recesses are formed minutely nucleation surfaces ($S_{NDL}$)12 comprising a material with greater nucleation density (ND) which is different from the material forming the nonnucleation surface ($S_{NDS}$), and single crystals 17 are formed in the same manner as in the fifth embodiment.

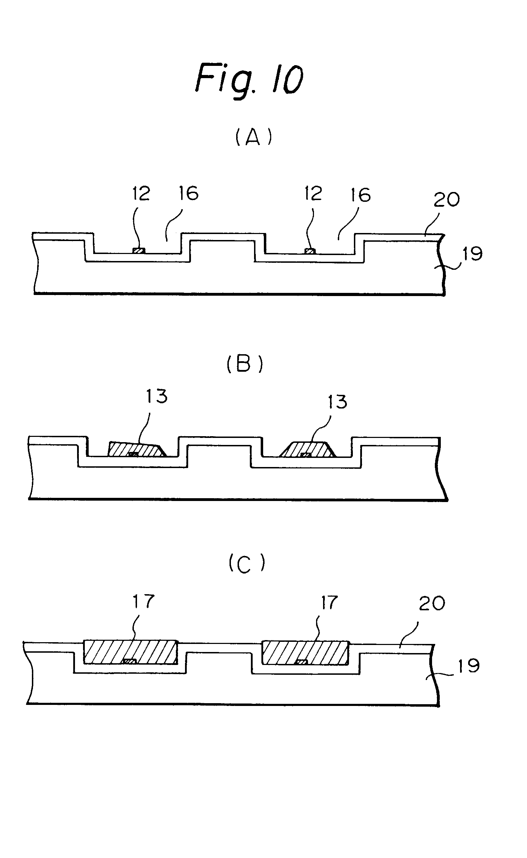

Figs. 10(A)-10(C) are illustrations of the formation steps of a crystal showing a fifth embodiment of the present invention. After formation of recesses in a desired substrate, a thin film nonnucleation surface ($S_{NDS}$)20 comprising a material with sufficiently small nucleation density (ND) enabling selective nucleation is formed, and following the same procedure as in the above embodiments, single crystals 17 can be formed.

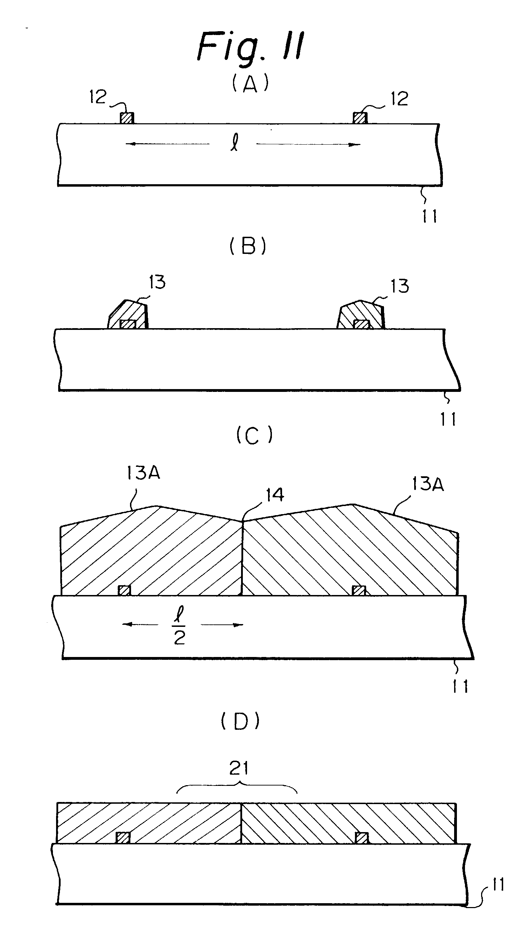

Figs. 11(A)-11(D) are illustrations of the steps for forming crystal showing a sixth embodiment of the present invention.

Figs. 11(A)-11(C) are the same as Figs. 4(A)-4(C). That is, a plurality (two in the figure) of nucleation surfaces 12 are formed with an interval of $\underline{\ell}$, and single crystal grains 13 subjected to overgrowth on the nucleation surfaces 12 are formed. By permitting the single crystal grains 13 to further grow to form single crystals 13A, a grain boundary 14 is formed approximately at the center between the nucleation surfaces ($S_{NDL}$) 12, and by flattening the surface of single crystal 13A, a polycrystalline layer 21 with regular grain sizes which are approximately equal to $\underline{\ell}$ as shown in Fig. 11 (D) can be obtained.

Since the grain size of the polycrystalline layer 21 is determined by the interval $\underline{\ell}$ between the nucleation surfaces ($S_{NDL}$) 12, it becomes possible to control the grain size of the polycrystal. In the prior art, the grain size of a polycrystal was changed by a plural number of factors such as the formation method, formation temperature, etc., and also when preparing a polycrystal with large grain size, it had a grain size distribution with a considerable width. However, according to the present invention, the grain size and grain size distribution can be determined with good controllability by the interval $\underline{\ell}$ between the nucleation surfaces 12.

Of course, as shown in Fig. 6, the above polycrystal layer 21 may be formed by forming a non-nucleation surface ($S_{NDS}$) 5 with small nucleation density (ND) on a desired substrate 4 and nucleation surfaces ($S_{NDL}$) 12-1, 12-2 with greater nucleation density (ND). In this case, as already mentioned, the substrate material and structure are not limited, but the polycrystal layer 21 can be formed by controlling the grain size and the grain size distribution.

Next, the specific method for forming a single crystal layer or a polycrystal layer in the above respective embodiments is described in more detail by referring primarily to the first embodiment shown in Fig. 4 and the sixth embodiment shown in Fig. 11

By thermal oxidation of an Si single crystal wafer to form an $SiO_2$ layer on the surface, a substrate 11 is obtained with its surface being formed into non-nucleation surface ($S_{NDS}$). Of course, a quartz substrate which is a material with small nucleation density (ND) can be also used as the substrate 11, or alternatively non-nucleation surface ($S_{NDS}$) may be provided by forming $SiO_2$ layer on the surface of any desired base substrate such as metal, semiconductor, magnetic material, piezoelectric material, insulator, etc., by use of the sputtering method, the CVD method, the vacuum vapor deposition method, etc. Also, as the material forming non-nucleation surfaces ($S_{NDS}$), $SiO_2$ is desirable, but $SiO_x$ ($0 < x < 1$) with the value of $\underline{x}$ being varied may be also employed.

On the $SiO_2$ layer of the substrate 11 having $SiO_2$ layer thus formed on the surface is deposited as silicon nitride layer (e.g. $Si_3N_4$ layer) or a polycrystalline silicon layer according to the reduced pressure chemical vapor deposition method, and subsequently the silicon nitride layer or polycrystalline silicon layer is subjected to patterning according to conventional lithographic technique or lithographic technique by use of X-ray, electron beam or ion beam, whereby nucleation surface ($S_{NDL}$) 12 having fine area of preferably 10 μm or less, more preferably several micron or less, optimally about 1 μm or less.

Subsequently, for example, by the selective use of a suitable gas among the abovementioned gases and according to the FOCVD method, for example an Si single crystal is selectively grown on the above substrate 11. In this procedure, the substrate temperature, pressure, etc., may be conveniently determined, but the substrate temperature may be preferably 100 to 600 °C.

Within a time of about some 10 minutes, by selection of optimum growth conditions, grains 13 of single crystals of Si grow on the nucleation surfaces ($S_{NDS}$) 12 comprising silicon nitride layer or polycrystalline silicon layer on the $SiO_2$ layer as the center, and grow to sizes of some 10 μm or more.

Subsequently, by the reactive ion etching (RIE) method utilizing the etching speed difference between Si and $SiO_2$, the surfaces of the single crystals 13A are flattened by selective etching of only Si, whereby a polycrystalline silicon layer 21 controlled in grain size can be formed (Fig. 11 (D)). Further, by removing the grain boundary portion, island-shaped single crystalline silicon layers 15-1, 15-2 are formed (Fig. 4(D)). If unevenness on the surface of the single crystal grains 13A-1, 13A-2 are large, mechanical polishing may be conducted before etching.

When electrical field effect transistors are formed according to conventional semiconductor device preparation technique on the single crystal silicon layers 15 thus formed with a size of some 10 μm or more containing no grain boundary, characteristics not inferior to that formed on single silicon wafer are exhibited.

Also, mutual interference between the adjacent single crystal silicon layers can be prevented, if they are electrically separated by an electrical insulator such as $SiO_2$, even if a complementary type electrical field effect transistor (C-MOS) may be constituted.

Also, since the thickness of the active layer of the device formed is thinner than the case when employing Si wafer, there is no erroneous actuation by the charges generated when radiation is irradiated. Further, due to lowering in unwanted capacity, speed-up of the device can be effected. Also, since any desired substrate can be used, a single crystal layer can be formed on a substrate of large area at lower cost than when employing Si wafer. Further, since a single crystal layer can be formed also on other semiconductors, piezoelectric materials, dielectric materials, etc., a multi-functional three-dimensional integrated circuit can be realized. Thus, the present invention exhibits a number of excellent effects.

(Composition of silicon nitride)

For obtaining sufficient nucleation density difference (ΔND) between the material ($M_S$) for formation of non-nucleation surface ($S_{NDS}$) and the material ($M_L$) for formation of nucleation surface ($S_{NDL}$) as described above, for polycrystalline silicon or $SiO_2$ as the material for formation of non-nucleation surface ($S_{NDS}$) to be used in combination, the material for formation of nucleation surface ($S_{NDL}$) is not limited to $Si_3N_4$, but silicon nitrides with various chemical composition ratios may be employed.

The chemical composition ratio of silicon nitride may be varied e.g. as follows.

In the plasma CVD method for forming silicon nitride film at low temperature by decomposition of $SiH_4$ gas and $NH_3$ gas in RF plasma, by varying the flow rate ratio of $SiH_4$ gas and $NH_3$ gas, the composition ratio of Si and N in the deposited silicon nitride film can be varied to a great extent.

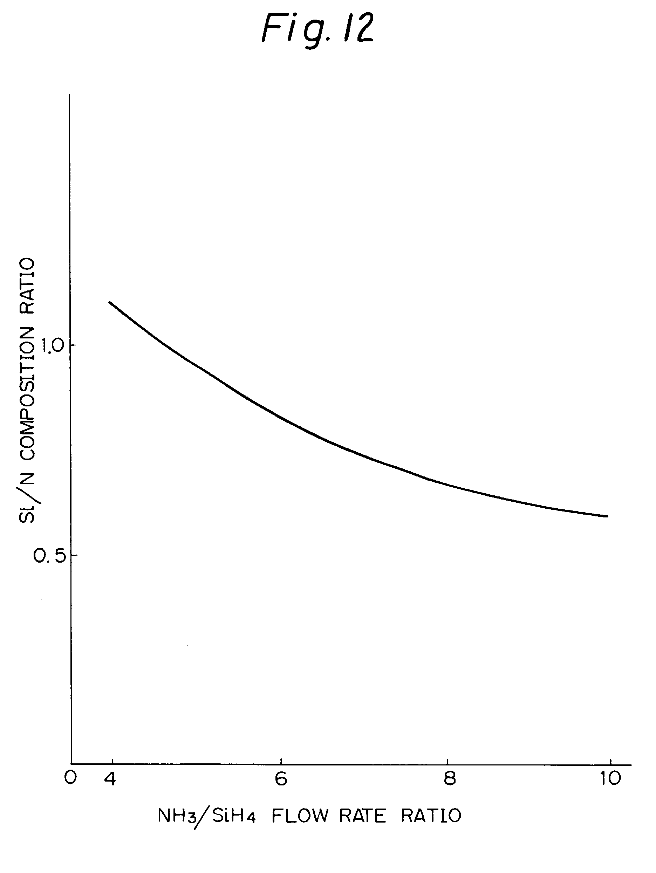

Fig.12 is a graph showing an example of the relationship between the flow rate ratio of $SiH_4$ and $NH_3$ and the composition ratio of Si and N in the silicon nitride film formed.

The deposition conditions at this time were RF output of 175 W, substrate temperature of 380 °C and the flow rate of $NH_3$ gas was varied with the $SiH_4$ gas flow rate being fixed at 300 cc/min. As shown in the same graph, by varying the gas flow rate ratio of $NH_3/SiH_4$ from 4 to 10, the Si/N ratio in the silicon nitride film was found to be varied from 1.1 to 0.58 according to Auger's electron spectrophotometry.

On the other hand, the composition of the silicon nitride film formed according to the reduced pressure CVD method by introducing $SiH_2Cl_2$ gas and $NH_3$ gas under the conditions of a reduced pressure of (0.3 Torr) and a temperature of about 800 °C was found to be $Si_3N_4$ (Si/N = 0.75) which is approximately the stoichiometric ratio.

Also, the silicon nitride film formed by heat treatment of Si at about 1200 °C in ammonia or $N_2$ (hot nitrification method) can be obtained with a composition further approximate to the stoichiometric ratio, since the formation method is performed under thermal equilibrium.

By use of silicon nitrides formed by the various methods as described above as the material for forming nucleation surface ($S_{NDL}$) with higher nucleation density than $SiO_2$, the above nucleus of Si can be grown on the nucleation surface ($S_{NDL}$) comprising silicon nitride to form Si single crystal based on the nucleation density ($\Delta ND$) corresponding to the chemical composition ratio of silicon nitride.

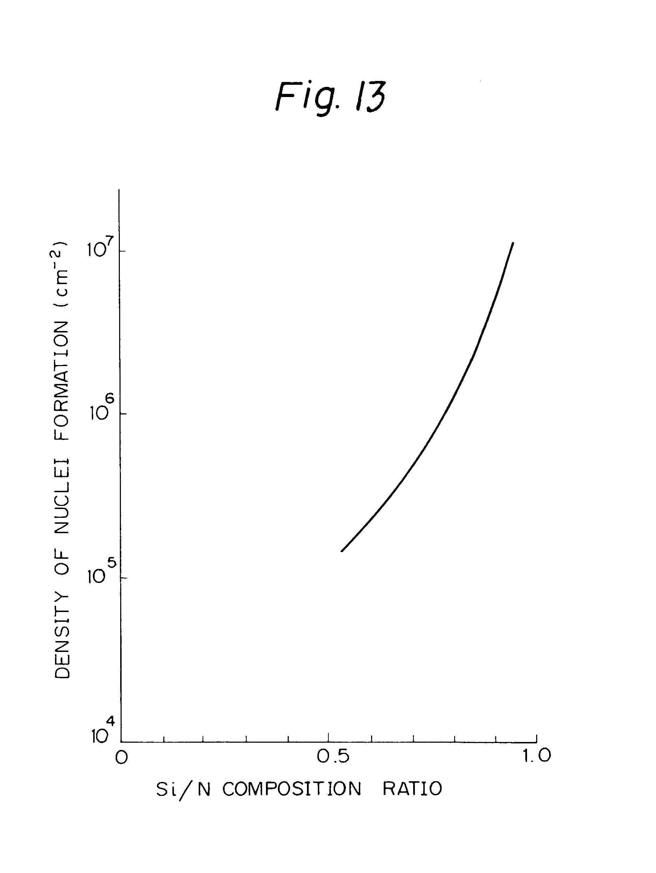

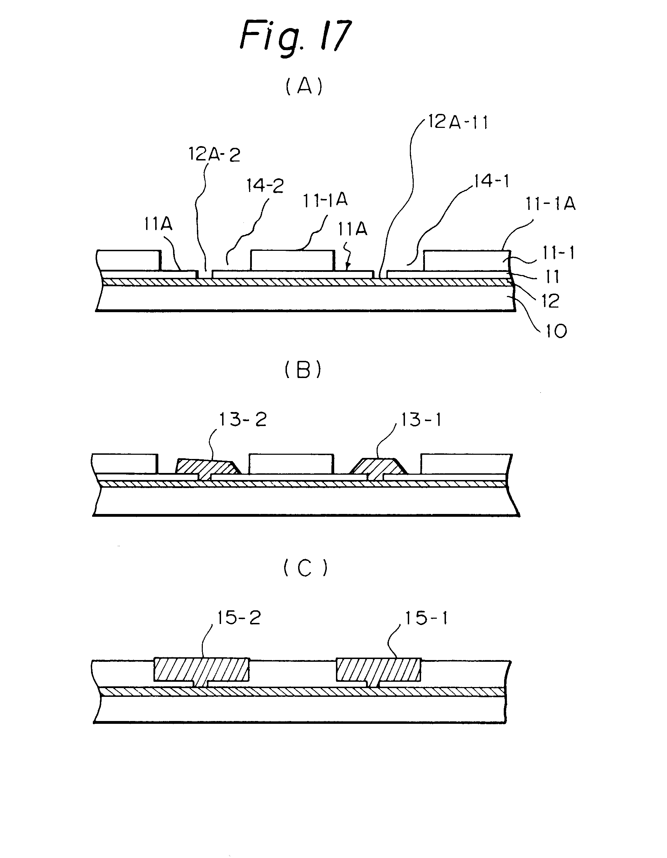

Fig. 17 is a graph showing the relationship between Si/N composition ratio and nucleation density (ND). As shown in the same graph, by varying the chemical composition ratio of the silicon nitride film, the nucleation density of the Si single crystal nucleus formed thereon changes to a great extent. The nucleation conditions in the graph shown in Fig. 13 correspond to the case when Si single crystal nucleus was formed by reacting $SiCl_4$ gas reduced to 2.33 Pa (175 Torr) with $H_2$ at 1000°C. Of course, another graph will be obtained if nucleation conditions such as gas species, pressure, temperature, etc., are changed.

The phenomenon that the nucleation density thus changes according to the chemical composition ratio of silicon nitride affects the size (area) of the nucleation surface ($S_{NDL}$) when employing silicon nitride as the material for forming the nucleation surface ($S_{NDL}$) which is formed sufficiently finely to the extent that a single nucleus may be grown. That is, when employing silicon nitride having a composition with great nucleation density (ND) only a single crystal can be formed on the nucleation surface ($S_{NDL}$) by forming the nucleation surface ($S_{NDL}$) extremely finely as compared with the silicon nitride with relatively smaller nucleation density (ND).

Such a point is applicable as a similar tendency for other materials for forming nucleation surface ($S_{NDL}$).

It is desirable to select a nucleation density (ND) and a size of nucleation surface ($S_{NDL}$) formed of silicon nitride, etc., capable of forming only a single crystal suitably as desired. For example, under the nucleation condition for obtaining a nucleation density (ND) of about $10^5$ cm$^{-2}$, it is possible to form selectively only a single nucleus, if the size of the nucleation surface ($S_{NDL}$) comprising silicon nitride is about 4 μm or less. The Si/N ratio in that case is about 0.5.

(Formation of nucleation surface ($S_{NDL}$) by ion injection)

As another method for realizing nucleation density difference (AND) when forming Si single crystal nucleus, ion injection of Si, N, P, B, F, Ar, He, C, As, Ga, Ge, etc., may be effected locally onto the $SiO_2$ surface which is a material for forming non-nucleation surface ($S_{NDS}$) with smaller nucleation density to form a modified region with a desired size on the surface of the $SiO_2$ layer, and utilize this modified region as the nucleation surface ($S_{NDL}$) with greater nucleation density (ND).

For example, the $SiO_2$ layer surface is covered with a photoresist layer and the desired portions are exposed, developed, and dissolved to have the $SiO_2$ layer surface exposed.

Subsequently, by use of $SiF_4$ gas as the source gas, Si ions are implanted onto the $SiO_2$ layer surface portion exposed at 10 keV at a density of $1 \times 10^{16}$ - $1 \times 10^{18}$ cm$^{-2}$. The projected flying distance in this case is 11.4nm (114Å), and the Si concentration on the exposed surface of $SiO_2$ layer reaches about $10^{22}$ cm$^{-3}$. Since the $SiO_2$ layer is originally amorphous, the modified region made excessively enriched in Si by injection of Si ions is also amorphous.

For formation of a modified region, ion injection can be effected with the use of a resist as the mask, but it is also possible to inject a narrowed Si ion beam selectively at a desired position on the $SiO_2$ layer surface within a desired area without use of a resist mark by use of converged ion beam technique.

After having thus effected Si ion injection, by peeling of the resist on the remaining portion, Si excessive modified region is formed in the $SiO_2$ layer surface portion at a desired position with a desired size. On the modified region of the $SiO_2$ layer surface portion having such modified region formed, Si single crystal is permitted to grow in vapor phase.

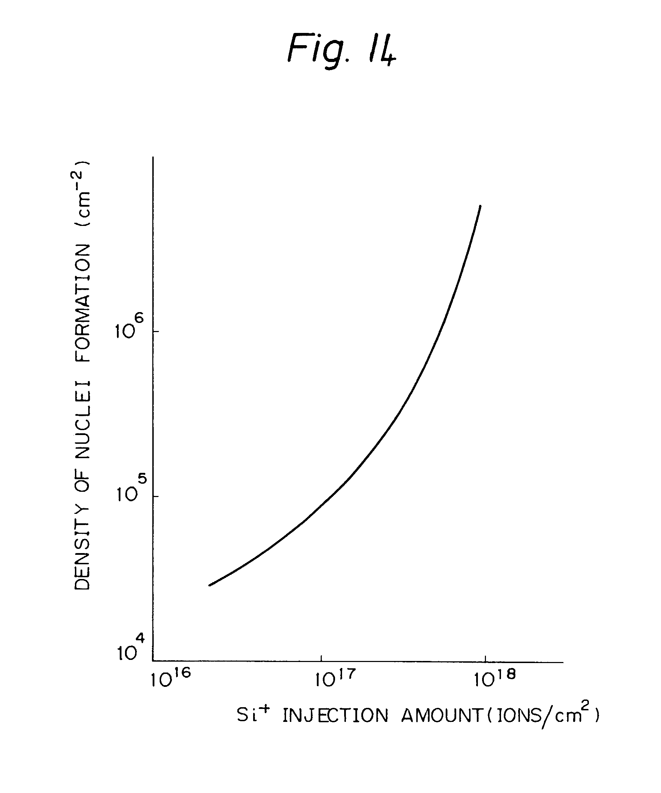

Fig. 14 is a graph showing the relationship between the injected amount of Si ions and the nucleation density (ND).

As shown in the same graph, it can be understood that nucleation density (ND) is increased as the Si$^+$ injected amount is more.

Therefore, by forming this modified region sufficiently finely, only single nucleus of Si can be permitted to grow with this modified region as the nucleation surface ($S_{NDL}$), whereby a single crystal can be grown as described above.

Formation of the modified region to a sufficiently fine size to the extent for growth of only a single nucleus can be accomplished easily by patterning of a resist, or narrowing of the beam of converged ion beam.

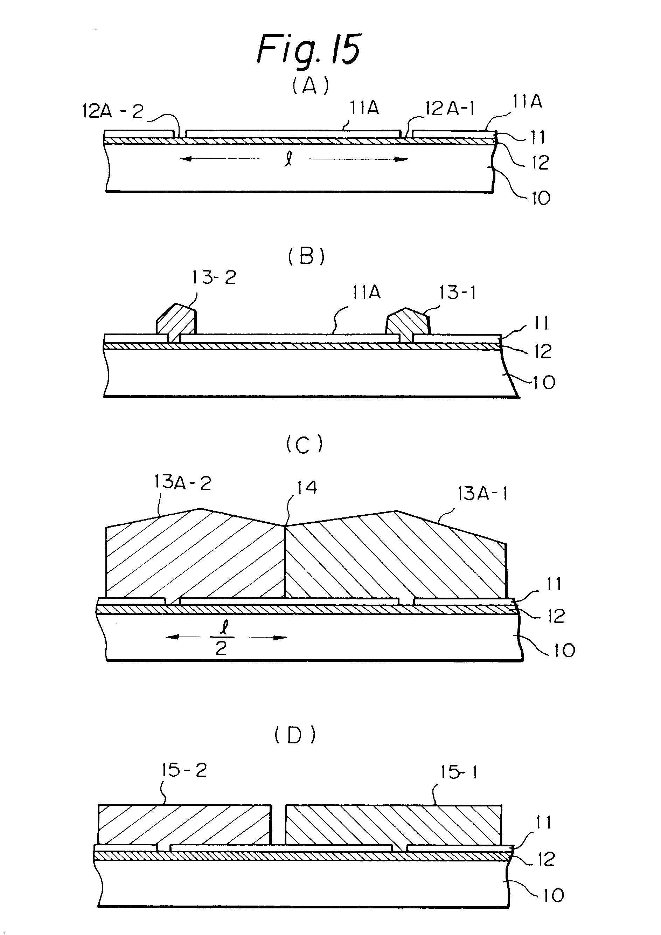

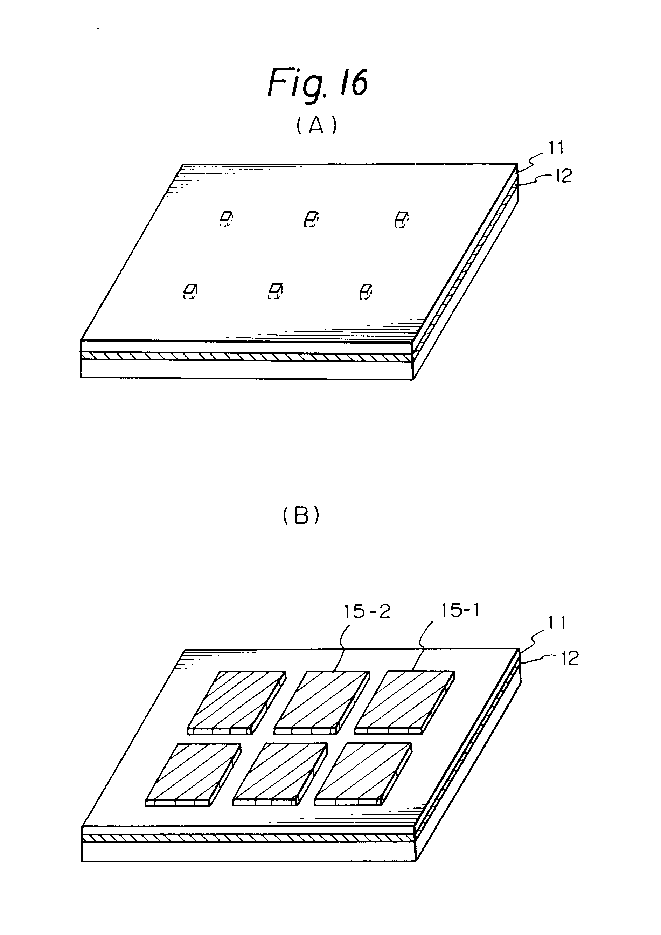

Figs. 15(A) - 15(D) are illustrations of the formation steps showing a seventh embodiment of the present invention, and Figs. 16(A) and 16(B) are perspective views corresponding to Figs.15(A) and 15(D).

As shown in Fig. 15(A) and Fig.16(A), on an appropriate base substrate 10 such as glass substrate, etc., an amorphous insulating thin film 12 with relatively greater nucleation density (ND) such as $Si_3N_4$, etc., is provided, and on said thin film 12 is formed selectively a thin film 11 at a desired position with a different material having smaller nucleation density relative to the material forming the thin film 12 which enables the above selective nucleation with an interval of a distance $\underline{\ell}$, thereby arranging nucleation surfaces ($S_{NDL}$)12A-1, 12A-2 with sufficiently small areas so as to form only single nucleus thereon. This distance $\underline{\ell}$ may be set at a size which is equal to or greater than the size of the single crystal region required for formation of a semiconductor device or a group of devices.

Next, by selecting appropriate crystal forming conditions, on the nucleation surfaces ($S_{NDL}$)12A-1, 12A-2 only a nucleus of a crystal forming material is formed. That is, as described above, the nucleation surfaces 12A-1, 12A-2 are required to be formed to a sufficiently fine size (area) to the extent that only a single nucleus may be formed. The size of the nucleation surfaces ($S_{NDL}$)12A-1, 12A-2, which may be different depending on the kind of the material, may be several microns or less. Further, the nucleus formed as above grows while maintaining the single crystal structure, and become island-shaped single crystal grains 13-1, 13-2 as shown in Fig. 15 (B). For forming island-shaped single crystal grains 13-1, 13-2, it is desirable to determine the conditions so that substantially no nucleation may occur at all on other surfaces than the nucleation surfaces ($S_{NDL}$)12A-1, 12A-2 [ non-nucleation surface ($S_{NDS}$)11A].

The crystal direction in the normal line d direction of the thin film 12 of the island-shaped single crystal grains 13-1, 13-2 is determined so as to make the interface energy of the material of the film 12 and the material forming nucleus minimum. For, surface or interface energy has anisotropy depending on the crystal face. However, as already mentioned, the crystal direction within the surface plane in amorphous surface is not determined.

The island-shaped single crystal grains 13-1, 13-2 further grow to become single crystals 13A-1, 13A-2 until the adjacent single crystals 13A-1, 13A-2 contact each other as shown in Fig. 15(C), but since the crystal directions within the substrate plane vary from one single crystal to another, a crystal grain boundary 14 is formed at the intermediate position between the nucleation surfaces ($S_{NDL}$) 12-1 and 12-2.

Subsequently, the single crystals 13A-1, 13A-2 grow three-dimensionally, but crystal faces with slow growth speed appear as the facet. For this reason, the surfaces of single crystals 13A-1, 13A-2 are flattened by etching or polishing, and further the portion of the grain boundary 14 is removed to form thin films of single crystals 15-1, 15-2, ... containing no grain boundary in shape of lattices as shown in Fig. 15(D) and Fig. 16(B). The size of the single crystal films 15-1, 15-2, ... is determined by the interval $\underline{1}$ between the nucleation surfaces ($S_{NDL}$)12A-1, 12A-2 as described above. That is, by determining appropriately the formation pattern of the nucleation surface ($S_{NDL}$) 12A-1, 12A-2, the position of the grain boundary can be controlled to form single crystal with desired sizes at a desired arrangement.

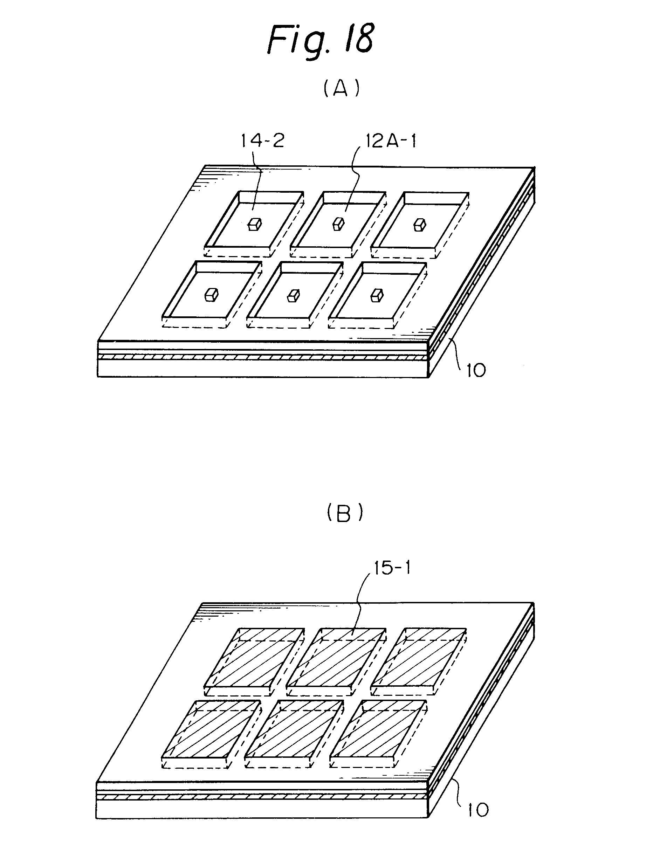

Figs. 17 (A) - 17(C) are illustrations of the formation steps showing an eighth embodiment of the present invention, and Figs. 18(A) and 18(B) are perspective views of the substrates in Figs.17(A) and 17(C).

First, as shown in Fig. 17(A) and Fig. 18(A), similarly as shown in the step (A) in Fig. 4, thin film 12 and 11 are provided on the base substrate 10 to form nucleation surfaces ($S_{NDL}$)12A-1, 12A-2 and non-nucleation surface ($S_{NDS}$) 11A. Subsequently, so that concavities 14-1, 14-2 with desired sizes and shapes may be provided at the corresponding positions to the nucleation surfaces ($S_{NDL}$)12A-1, 12A-2, a thin film 11-1 is formed with same material as the thin film IIa or a material having nucleation density equal to or smaller than said material. Thus, a substrate for formation of crystal having nucleation surfaces ($S_{NDL}$)12A-1, 12A-2 with sufficiently fine sizes for forming only single nucleus within recesses 14-1, 14-2 is formded.

Subsequently, as shown in Fig.17(B), island-shaped single crystal grains 13-1, 13-2 are grown similarly as in the first embodiment.

And, as shown in Fig. 17(C) and Fig. 18(B), single crystal grains 13-1, 13-2 are grown until embedding the concavity 14-1, 14-2 to form single crystals 15-1, 15-2.

In this embodiment, since single crystal grains 13-1, 13-2 grow within the recess 14-1, 14-2, the steps of flattening and removing the grain portion may be unnecessary.

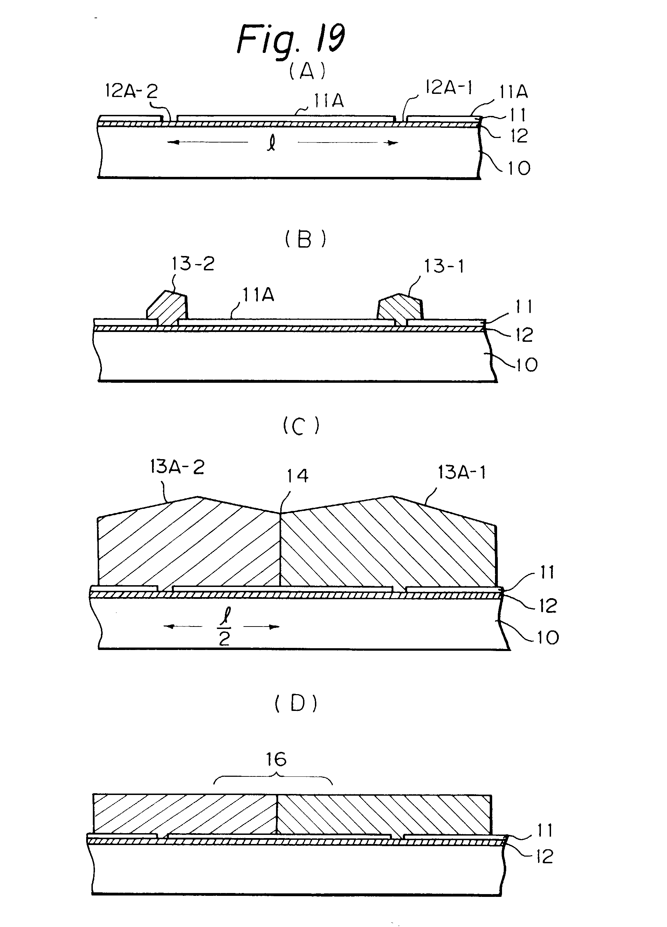

Figs. 19(A) - 19(D) are illustrations of the steps for forming film showing a ninth embodiment of the present invention.

Figs. 19(A) - 19 (C) are the same as Figs. 15(A) - 15 (C). That is, a plurality (two in the Figure) of nucleation surfaces 12A-1, 12A-2 are formed with an interval of $\underline{\ell}$, and single crystal grains 13-1, 13-2 subjected to over growth on the nucleation surfaces 12A-1, 12A-2 are formed. By permitting the single crystal grains 13-1, 13-2 to further grow to form single crystals 13A-1, 13A-2, a grain boundary 14 is formed approximately at the center between the non-nucleation surfaces ($S_{NDS}$)11A, and by flattening the surface of single crystal 13A-1, 13A-2, a polycrystalline layer 16 with regular grain sizes which are approximately equal to $\underline{\ell}$ can be obtained.

Since the grain size of the polycrystalline layer 16 is determined by the interval $\underline{\ell}$ between the nucleation surfaces ($S_{NDL}$)12A-1, 12A-2, it becomes possible to control the grain size of the polycrystal. In the prior art, the grain size of a polycrystal was changed by a plural number of factors such as the formation method, formation temperature, etc., and also when preparing a polycrystal with large grain size, it had a grain size distribution with a considerable width. However, according to the present invention, the grain size and grain size distribution can be determined with good controllability by the interval $\underline{\ell}$ between the nucleation surfaces ($S_{NDL}$)12A-1, 12A-2.

A polycrystal layer may be formed as above by forming a thin film 5 having a non-nucleation surface ($S_{NDS}$)5A with small nucleation density (ND) on a desired substrate 9 and plural nucleation surfaces ($S_{NDL}$)9A with greater nucleation density (ND) at desired positions and intervals. In this case, as already mentioned, the substrate material and structure are not limited, provided that the nucleation density difference (ΔND) is taken into consideration, but the polycrystal layer can be formed by controlling the grain size and the grain size distribution.

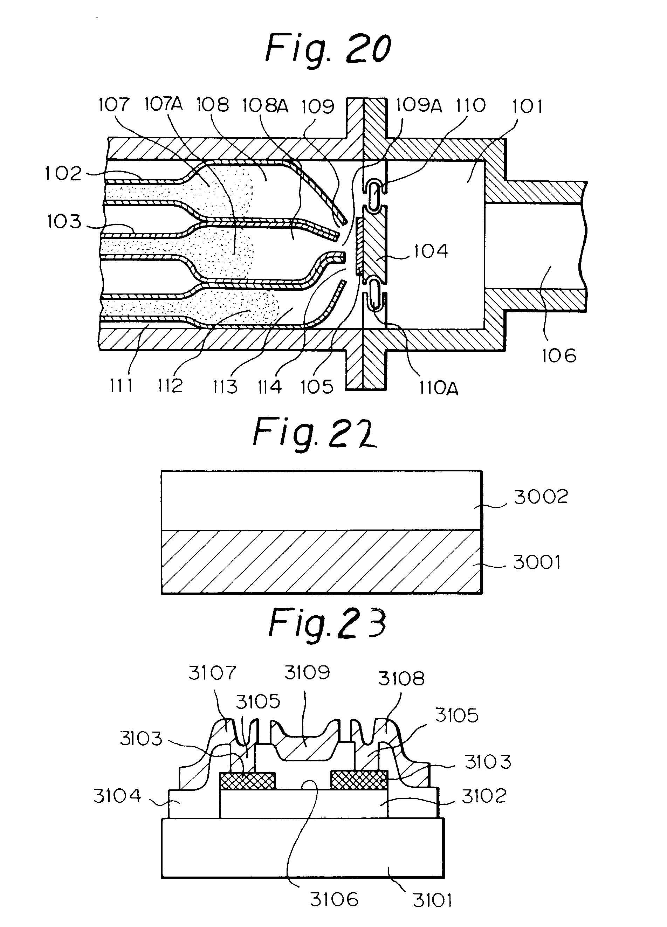

Fig. 20 is a partial sectional view showing the schematic construction of an example of apparatus for forming deposited film in which the process of the present invention is practiced.

In Fig.20, 101 is a deposition chamber (film forming space) in which deposition of silicon thin film is effected, and the deposition chamber 101 is internally connected to an evacuation system not shown through an evacuation outlet 106, whereby the deposition chamber 101 can be maintained at a desired pressure. In the deposition chamber 101, there are provided a set of the introducing pipe 102 for radicals (SX) containing e.g., silicon and a halogen which is the active species (A) and the introducing pipe 103 for e.g., hydrogen radicals as active species (B), respectively. The tips of the respective radical introducing pipes are thick at the acting chambers 108, 108A, and narrowed at the outlets 109, 109A. Within the deposition chamber 101, a substrate supporting member 104 is held by the roller 110 so as to be movable reciprocally in the direction perpendicular to the paper surface. And on said supporting member 104 is held a support 105 for deposition. The respective radicals coming out from the outlet 109, 109A are mixed and reacted with each other in the vicinity of the substrate within the deposition chamber 101 to form a film on the substrate 105. The radicals (SX) and hydrogen radicals are formed from the respective starting material gases in the active species forming chambers such as heating furnaces or plasma chambers, etc., not shown, respectively, and thereafter introduced through the introducing pipes 102, 103, respectively into the acting chambers 108, 108A. Their amounts are controlled by massflow controllers on the gas source side from the heating furnace or plasma chamber.

Roller 110 is provided only for depositing silicon thin film over the whole surface of the substrate by moving the substrate 105.

The introducing pipe 111 is an introducing pipe for another gas having chemical or physical etching activity (etching gas), and in some cases the etching gas is previously activated in the heating furnace or plasma furnace not shown and led to the outlet 114. From the outlet 114, the etching gas for attacking the film is released to cut or exclude selectively the bonds except in the growth direction of the characteristics of the film. Introduction of the etching gas, other than through such separate introduction pipes, can be also done through the introduction pipes 102, 103 mixed with a starting gases, when the reactivity with the starting gases is low.

The present invention is described in more detail by referring to Examples.

Example 1

The substrate 118 was prepared according to the steps shown in Fig. 21.

First, a glass substrate 206 comprising substantially uniform composition material as shown in Fig. 22 (A) was washed and then according to the thermal CVD method amorphous SiN(A-SiN) thin film 207 was formed with a thickness of about 2μm on the whole surface of the substrate 206 [Fig. 21(B)].

Subsequently, surface annealing of the above A-SiN thin film 207 was effected in $N_2$ atmosphere by means of a laser annealing device on the above A-SiN thin film 207 to form a crystalline $Si_3N_4$ ($C-Si_3N_4$) 208 on the surface layer of the A-SiN thin film 207 (to the depth of about 1 μm) [Fig. 21(C)].

At this time, the laser was irradiated with Ar-CW laser of 488 nm (4880Å), at a scanning speed of 2.5 cm/sec and at an energy of 10 W. Subsequently, the surface of the $C-Si_3N_4$ layer 208 was scanned by means of the above laser annealing device in $O_2$ atmosphere to form locally the $SiO_2$ layer 209 [Fig. 21(D)].

According to the steps as described above, the substrate 118 having $C-Si_3N_4$ layer 208A exposed at constant intervals with other portions being covered with $SiO_2$ layer 209 was formed. The domains of $C-Si_3N_4$ layer 208A exposed on the substrate surface were about 4 μm in diameter with intervals of 3 μm.

Next, by use of apparatus shown in Fig. 20, a crystalline silicon thin film was formed on the above substrate 118.

First, by use of $Si_2F_6$ as the starting gas for formation of radicals containing silicon and halogen, it was permitted to flow at a flow rate of 100 SCCM into the reaction furnace maintained at 800 °C to be decomposed therein, followed by release through the introducing pipe 102 into the acting chamber 108. At the same time Ar gas was permitted to flow through the introducing pipe 111 at a rate of 150 SCCM, and a microwave of 2.45 GHz was introduced at a power of 1.0 w/cm$^2$ into said introducing pipe 103 to effect discharging and decompose $H_2$, followed by release of the decomposed gas into the activating chamber 108 at a flow rate of 25 SCCM. The substrate temperature was maintained at 270 °C and the pressure at 13.3 Pa (0.1 Torr).

Fig. 21(E) is a schematic drawing showing the cross-section of the crystalline silicon deposited film 204 obtained on the substrate 118.

The size of the crystal grain was determined so that the crystal grain boundary 210 was at the same distance from the exposed portions 208A of the crystalline substrate 209 other than the $SiO_2$ layer 204.

When crystallinity of the silicon deposited film was evaluated according to the X-ray diffractometry and electron beam diffractometry by use of respective samples obtained, they were confirmed to be polycrystalline silicon films. Further, the grain size of the polycrystalline silicon determined by the Scherrar method was 20±0.5 μm. The variance in crystal grain size was substantially negligible over the whole substrate.

Also, when the surface state of the sample was observed by a scanning type electron microscope, the smoothness was found to be good without wavy pattern, etc., and the film thickness irregularity was ±4% or less. Also when the mobility and electroconductivity of the crystalline Si deposited film of the sample prepared were measured according to the Van der Pauw method, they were found to be 150 (cm/V·sec) and 5x10$^{-6}$ (S·cm$^{-1}$), respectively.

Example 2

By use of the same conditions as in sample No. 1, a thin film transistor (hereinafter abbreviated as TFT) as shown in Fig. 23 was prepared. After deposition of a Si semiconductor polycrystalline layer 3002 as shown in Fig.22 with a film thickness of 0.5 µm on a glass (Corning #7059) base plate 3001 subjected to patterning with SiNH under the above conditions, TFT was prepared by use of the process for preparation of the upper gate coplanar TFT.

First, according to the glow discharge method, an n+ layer (specific resistivity $\sigma \simeq 1\Omega\cdot cm$) which is the ohmic contact layer 3103 doped with P was formed to a thickness of 100 nm (1000Å), and then an active layer 3102 was remained by photolithography, followed by etching of the channel portion 3106 to form the above contact layer 3103. Then, by use of the glow discharge method, $NH_3$ and $SiH_4$ were decomposed to deposit a Si-N-H film with a film thickness of 300 nm (3000Å), dielectric constant of 67 and a dielectric strength $3 \times 10^6$ V/cm, $V_{FB} \simeq OV$ at a substrate temperature of 200 °C. Then contact holes 3105 for source and drain were opened, Al was deposited to 500 nm (5000Å) by vacuum vapor deposition as the upper electrode, and the source electrode 3107, the gate electrode 3109 and the drain electrode 3108 were respectively formed by photolithography. The gate width W and the gate length L were respectively 650 µm ($\mu$) and 22 µm ($\mu$). The characteristics when the drain electrode was earthed and various $\oplus$ voltages were applied on the source electrode and the gate electrode were measured. In the drain current $I_D$ - drain voltage $V_D$ characteristic, good saturation characteristics were obtained in both Nos. 1 and 2 to give a high current of $7 \times 10^{-4}$ A at a gate voltage of 10 V and a drain voltage of 10 V. The TFT characteristics obtained from the results of measurement of the drain current $I_D$ at various gate voltage $V_D$ are shown in Table 1.

The TFT by use of the film as obtained above was found to have good characteristics.

Table 1

| Sample No. | 1 | 2 |
|---|---|---|
| Ratio of the maximum value and the minimum value of drain current* | $2.6 \times 10^5$ | $3.9 \times 10^5$ |
| Electrical field effect mobility ** (cm$^2$/V sec) | 41 | 66 |
| Threshold value voltage** (V) | 5.1 | 2.9 |

*measured by varying gate voltage (drain voltage $V_D$ = 10 V made constant)

** Calculated from $\sqrt{I_D}$ - $V_G$ dependency

The method for forming deposited film of the present invention can form a deposited film only by contacting an activated species (A) with an activated species (B), and has the advantage of requiring particularly no reaction exciting energy from the outside. Accordingly, it becomes possible to lower the substrate temperature. Also, since the material for nucleating selectively the crystal nucleus can be arranged at a desired position on the substrate surface, any desired polycrystalline or single crystalline deposited film with extremely high orientation and great grain size can be formed. Further, simultaneously with saving of energy, it is possible to obtain a crystalline deposited film having uniform film quality and characteristics over a large area with easy management of the film quality. Further, a crystalline film excellent in productivity, bulk productivity and having high quality with excellent electrical, optical semiconductive and other physical properties can be obtained with ease.

**Claims**

1. A method of depositing silicon single crystals on the surface of a substrate, comprising:

    establishing at a free surface of said substrate a plurality of deposition surface areas each being of a different composition from that of the adjacent deposition surface area and having under chosen conditions of deposition a property of nucleating silicon at a higher nucleation density than that of said adjacent deposition surface area and each of said deposition surface areas being at spaced apart locations on said substrate separated by said adjacent deposition surface area; and
    depositing said silicon on the exposed free surface of the substrate so that said silicon nucleates selectively on said plurality of deposition surface areas;

    characterised in that:

    i) said plurality of surface areas have a surface property which excludes an epitaxial growth of a single crystal of said silicon;

ii) each of said plurality of deposition surface areas is limited to a size such that silicon forms on each of said plurality of deposition surface areas under said chosen conditions of deposition only one single nucleus of supracritical size which grows into one single crystal of silicon;

iii) the deposition of said silicon is performed by the steps of:

- introducing a chain or cyclic silane compound of which hydrogen atoms are partially or wholly substituted with halogen atoms into a first activation chamber, forming a first activated species in said first activation chamber from said chain or cyclic silane compound by employing an activation energy;
- introducing a hydrogen gas and/or a halogen gas into a second and separate activation chamber, forming second activated species in said second and separate activation chamber from said hydrogen gas and/ or a halogen gas by employing an activation energy; and then
- bringing said first and second activated species from said first and second activation chambers into a reaction chamber containing said substrate, whereby said first and second activated species come into chemical contact to produce a plurality of exited precursors of which at least one is the source of silicon for said silicon single crystals.

2. A method according to claim 1 wherein said halogen gas is fluorine gas.

3. A method according to claim 1 wherein said halogen gas is chlorine gas.

4. A method according to any preceding claim wherein a compound selected from $PH_3$, $P_2H_4$, $PF_3$, $PF_5$, $PCl_3$, $AsH_3$, $AsF_3$, $AsF_5$, $AsCl_3$, $SbH_3$, $SbF_5$, $BiH_3$, $BF_3$, $BCl_3$, $BBr_3$, $B_2H_6$, $B_4H_{10}$, $B_5H_{11}$, $B_6H_{10}$, $B_6H_{12}$, $AlCl_3$ is introduced, in the gaseous state, directly into said reaction chamber to dope the deposited silicon with an impurity.

5. A method according to any preceding claim 1 to 3 wherein a compound selected from $PH_3$, $P_2H_4$, $PF_3$, $PF_5$, $PCl_3$, $AsH_3$, $AsF_3$, $AsF_5$, $AsCl_3$, $SbH_3$, $SbF_5$, $BiH_3$, $BF_3$, $BCl_3$, $BBr_3$, $B_2H_6$, $B_4H_{10}$, $B_5H_{11}$, $B_6H_{10}$, $B_6H_{12}$, $AlCl_3$ is activated in either of said first or second activation chambers, or else in a third activation chamber, and then introduced into said reaction chamber to dope the deposited silicon with an impurity.

6. A method according to any preceding claim wherein said plurality of deposition surface areas are of amorphous material.

7. A method according to any preceding claim wherein said adjacent deposition surface area is of silicon oxide and said plurality of deposition surface areas are of silicon nitride.

8. A method according to any preceding claim 1 to 6 wherein said adjacent deposition surface area is of silicon dioxide and said plurality of deposition surface areas are areas of said silicon dioxide implanted with ions selected from Si, N, P, B, F, Ar, He, C, As, Ga or Ge.

9. A method according to claim 1 wherein said adjacent deposition surface area is a surface of an amorphous insulating substrate and said plurality of deposition surface areas are of a material different than the material of said adjacent deposition surface area and said plurality of deposition surface areas are arranged on said adjacent deposition surface area.

10. A method according to claim 1 wherein said adjacent deposition surface area is a surface of a thin film and said plurality of deposition surface areas of a material different than the material of said adjacent deposition surface area and said plurality of deposition surface areas are arranged on said adjacent deposition surface area.

11. A method according to claim 1 wherein said adjacent deposition surface area is a surface of an amorphous insulating substrate having recesses and said plurality of deposition surface areas of a material different than the material of said adjacent deposition surface area, and one of said plurality of deposition surface areas is provided on the surface of the base of a respective one of each of said recesses.

12. A method according to claim 1 wherein said adjacent deposition surface area is a surface of a thin film having recesses, which thin film is on the surface of a substrate, and said plurality of deposition surface areas are of a material different than the material of said adjacent deposition surface area and are of said plurality of deposition surface areas is provided on the surface of the base of a respective one of each of said recesses.

13. A method according to claim 1 wherein said adjacent deposition surface area is a surface of a thin film, which thin film is on a surface of a substrate having recesses, and one of said plurality of deposition surface areas is provided on said adjacent deposition surface area at the base of a respective one of each of said recesses.

14. A method according to claim 1 wherein said adjacent deposition surface area is a surface of a first thin film provided on an amorphous insulating second thin film of a material different than the material of said adjacent deposition surface area and said plurality of deposition surface areas are respective areas of the surface of said amorphous insulating second thin film exposed at openings of said first thin film.

15. A method according to claim 1 wherein said substrate is comprised of a base substrate, a first thin film on the surface of said base substrate, a second thin film on the surface of the first thin film, a third thin film, on the surface of the second thin film, said third film being provided with a plurality of recesses exposing respective areas of said second thin film, said second thin film having respective openings at the base of each respective recess exposing respective areas of said first thin film, wherein said adjacent deposition surface area is the exposed surface of said second and third thin films, said plurality of deposition surface areas are said areas of exposed first thin film, and said third thin film having under said chosen conditions of deposition a property of nucleating silicon at a nucleation density equal to or lower than said second thin film.

16. A method according to any of claims 9, 10 or 14 wherein single crystal grown from each single nucleus is grown until adjacent single crystals contact each other.

17. A method according to claim 16 wherein the surfaces of said single crystals are flattened by etching or polishing.

18. A method according to claim 17 wherein the grain boundaries formed between said single crystals are removed.


**Patentansprüche**

1. Verfahren zum Abscheiden von Einzelkristallen aus Silicium auf der Oberfläche eines Substrates mit den Schritten:

Schaffen auf einer freien Oberfläche des Substrates einer Vielzahl von Abscheidungsflächenbereichen, die jeweils eine andere Zusammensetzung als die des benachbarten Abscheidungsflächenbereiches besitzen und unter ausgewählten Abscheidungsbedingungen die Eigenschaft aufweisen, Siliciumkerne mit einer höheren Kernbildungsdichte zu bilden als die des benachbarten Abscheidungsflächenbereiches, wobei jeder der Abscheidungsflächenbereiche an voneinander beabstandeten Stellen auf dem Substrat angeordnet ist, die vom benachbarten Abscheidungsflächenbereich getrennt sind; und

Abscheiden des Siliciums auf der exponierten freien Oberfläche des Substrates derart, daß die Siliciumkerne selektiv auf der Vielzahl der Abscheidungsflächenbereiche gebildet werden;

dadurch gekennzeichnet, daß

i) die Vielzahl der Flächenbereiche eine Oberflächeneigenschaft besitzt, die ein epitaxiales Wachstum eines Einzelkristalls aus Silicium ausschließt;

ii) jeder aus der Vielzahl der Abscheidungsflächenbereiche auf eine solche Größe beschränkt ist, daß das Silicium auf jedem der Vielzahl der Abscheidungsflächenbereiche unter den ausgewählten Abscheidungsbedingungen nur einen einzigen Kern suprakritischer Größe bildet, der zu einem einzigen Siliciumkristall wächst;

iii) die Abscheidung des Siliciums durch die folgenden Schritte durchgeführt wird:

- Einführen einer kettenförmigen oder zyklischen Silanverbindung, bei der Wasserstoffatome teilweise oder vollständig durch Halogenatome substituiert sind, in eine erste Aktivierungskammer, Ausbilden einer ersten aktivierten Spezies in der ersten Aktivierungskammer aus der kettenförmigen oder zyklischen Silanverbindung durch Verwendung von Aktivierungsenergie;

- Einführen eines Wasserstoffgases und/oder Halogengases in eine zweite und separate Aktivierungskammer, Ausbilden der aktivierten Spezies in der zweiten und separaten Aktivierungskammer aus dem Wasserstoffgas und/oder einem Halogengas durch Verwendung von Aktivierungsenergie; und dann

- Bringen der ersten und zweiten aktivierten Spezies aus der ersten und zweiten Aktivierungskammer in eine Reaktionskammer, die das Substrat enthält, wodurch die erste und zweite aktivierte Spezies in chemischen Kontakt kommen und eine Vielzahl von angeregten Vorläufern bilden, von denen mindestens einer die Siliciumquelle für die Einzelkristalle aus Silicium bildet.

2. Verfahren nach Anspruch 1, bei dem das Halogengas Fluorgas ist.

3. Verfahren nach Anspruch 1, bei dem das Halogengas Chlorgas ist.

4. Verfahren nach einem der vorangehenden Ansprüche, bei dem eine Verbindung, die aus $PH_3$, $P_2H_4$, $PF_3$, $PF_5$, $PCl_3$, $AsH_3$, $AsF_3$, $AsF_5$, $AsCl_3$, $SbH_3$, $SbF_5$, $BiH_3$, $BF_3$, $BCl_3$, $BBr_3$, $B_2H_6$, $B_4H_{10}$, $B_5H_{11}$, $B_6H_{10}$, $B_6H_{12}$, $AlCl_3$ ausgewählt ist, im gasförmigen Zustand direkt in die Reaktionskammer eingeführt wird, um das abgeschiedene Silicium mit einer Verunreinigung zu dotieren.

5. Verfahren nach einem der Ansprüche 1 bis 3, bei dem eine Verbindung, die aus $PH_3$, $P_2H_4$, $PF_3$, $PF_5$, $PCl_3$, $AsH_3$, $AsF_3$, $AsF_5$, $AsCl_3$, $SbH_3$, $SbF_5$, $BiH_3$, $BF_3$, $BCl_3$, $BBr_3$, $B_2H_6$, $B_4H_{10}$, $B_5H_{11}$, $B_6H_{10}$, $B_6H_{12}$, $AlCl_3$, ausgewählt ist, in der ersten oder zweiten Aktivierungskammer oder in einer dritten Aktivierungskammer aktiviert und dann in die Reaktionskammer eingeführt wird, um das abgeschiedene Silicium mit einer Verunreinigung zu dotieren.

6. Verfahren nach einem der vorangehenden Ansprüche, bei dem die Vielzahl der Abscheidungsflächenbereiche aus amorphem Material besteht.

7. Verfahren nach einem der vorangehenden Ansprüche, bei dem der benachbarte Abscheidungsflächenbereich aus Siliciumoxid besteht und die Vielzahl der Abscheidungflächenbereiche aus Siliciumnitrid besteht.

8. Verfahren nach einem der Ansprüche 1 bis 6, bei dem der benachbarte Abscheidungsflächenbereich aus Siliciumdioxid besteht und die Vielzahl der Abscheidungsflächenbereiche Bereiche aus Siliciumdioxid, das mit Ionen implantiert ist, die aus Si, N, P, B, F, Ar, He, C, As, Ga oder Ge ausgewählt sind, sind.

9. Verfahren nach Anspruch 1, bei dem der benachbarte Abscheidungsflächenbereich eine Oberfläche eines amorphen isolierenden Substrates ist und die Vielzahl der Abscheidungsflächenbereiche aus einem Material besteht, das sich von dem Material des benachbarten Abscheidungsflächenbereiches unterscheidet, und bei dem die Vielzahl der Abscheidungsflächenbereiche auf dem benachbarten Abscheidungsflächenbereich angeordnet ist.

10. Verfahren nach Anspruch 1, bei dem der benachbarte Abscheidungsflächenbereich eine Oberfläche eines Dünnfilmes ist und die Vielzahl der Abscheidungsflächenbereiche aus einem Material besteht, das sich von dem Material des benachbarten Abscheidungsflächenbereiches unterscheidet, und bei dem die Vielzahl der Abscheidungsflächenbereiche auf dem benachbarten Abscheidungsflächenbereich angeordnet ist.

11. Verfahren nach Anspruch 1, bei dem der benachbarte Abscheidungsflächenbereich eine Oberfläche aus einem amorphen isolierenden Substrat ist, das Ausnehmungen aufweist, bei dem die Vielzahl der Abscheidungsflächenbereiche aus einem Material besteht, das sich von dem Material des benachbarten Abscheidungsflächenbereiches unterscheidet, und bei dem einer aus der Vielzahl der Abscheidungsflächenbereiche auf der Oberfläche der Basis einer entsprechenden Ausnehmung vorgesehen ist.

12. Verfahren nach Anspruch 1, bei dem der benachbarte Abscheidungsflächenbereich eine Oberfläche aus einem Dünnfilm ist, der Ausnehmungen aufweist und sich auf der Oberfläche eines Substrates befindet, und bei dem die Vielzahl der Abscheidungsflächenbereiche aus einem Material besteht, das sich von dem Material des benachbarten Abscheidungsflächenbereiches unterscheidet, und bei dem einer aus der Vielzahl der Abscheidungsflächenbereiche auf der Oberfläche der Basis von einer entsprechenden Ausnehmung vorgesehen ist.

13. Verfahren nach Anspruch 1, bei dem der benachbarte Abscheidungsflächenbereich eine Oberfläche aus einem Dünnfilm ist, der sich auf einer Oberfläche eines Substrates mit Ausnehmungen befindet, und bei dem einer der Vielzahl der Abscheidungsflächenbereiche auf dem benachbarten Abscheidungsflächenbereich auf der Basis einer entsprechenden Ausnehmung vorgesehen ist.

**14.** Verfahren nach Anspruch 1, bei dem der benachbarte Abscheidungsflächenbereich eine Oberfläche eines ersten Dünnfilmes ist, der auf einem zweiten amorphen isolierenden Dünnfilm aus einem Material, das sich vom Material des benachbarten Abscheidungsflächenbereiches unterscheidet, angeordnet ist, und bei dem die Vielzahl der Abscheidungsflächenbereiche entsprechende Bereiche der Oberfläche des zweiten amorphen isolierenden Dünnfilmes sind, die an Öffnungen des ersten Dünnfilmes exponiert sind.

**15.** Verfahren nach Anspruch 1, bei dem das Substrat ein Basissubstrat, einen ersten Dünnfilm auf der Oberfläche des Basissubstrates, einen zweiten Dünnfilm auf der Oberfläche des ersten Dünnfilmes und einen dritten Dünnfilm auf der Oberfläche des zweiten Dünnfilmes umfasst, wobei der dritte Dünnfilm mit einer Vielzahl von Ausnehmungen versehen ist, die entsprechende Bereiche des zweiten Dünnfilmes freigeben, der zweite Dünnfilm entsprechende Öffnungen an der Basis einer jeden entsprechenden Ausnehmung aufweist, die entsprechende Bereiche des ersten Dünnfilmes freigeben, der benachbarte Abscheidungsflächenbereich die freiliegende Oberfläche des zweiten und dritten Dünnfilmes ist, die Vielzahl der Abscheidungsflächenbereiche von den Bereichen des freiliegenden ersten Dünnfilmes gebildet wird und der dritte Dünnfilm unter den ausgewählten Abscheidungsbedingungen die Eigenschaft besitzt, Siliciumkerne mit einer Kernbildungsdichte zu bilden, die der des zweiten Dünnfilmes entspricht oder niedriger als diese ist.

**16.** Verfahren nach einem der Ansprüche 9, 10 oder 14, bei dem ein aus jedem Einzelkern gewachsenes Einzelkristall solange wachsen gelassen wird, bis benachbarte Einzelkristalle einander kontaktieren.

**17.** Verfahren nach Anspruch 16, bei dem die Oberflächen der Einzelkristalle durch Ätzen oder Polieren eingeebnet werden.

**18.** Verfahren nach Anspruch 17, bei dem die zwischen den Einzelkristallen gebildeten Korngrenzen entfernt werden.


**Revendications**

**1.** Procédé pour déposer des monocristaux de silicium sur la surface d'un substrat, comprenant les étapes consistant :

à établir au niveau d'une surface libre dudit substrat une pluralité de zones de surface de dépôt, chacune ayant une composition différente de celle de la zone de surface de dépôt adjacente et ayant, dans des conditions de dépôt choisies, une propriété de nucléation de silicium à une densité de nucléation supérieure à celle de ladite zone de surface de dépôt adjacente, et chacune desdites zones de surface de dépôt étant à des emplacements espacés sur ledit substrat séparée par ladite zone de surface de dépôt adjacente ;
à déposer le silicium sur la surface libre exposée du substrat de telle sorte que ce silicium subisse une nucléation sélective sur ladite pluralité de zones de surface de dépôt ;

caractérisé en ce que :

i) ladite pluralité de zones de surface a une propriété de surface qui exclut la croissance épitaxiale d'un monocristal de silicium ;
ii) chacune des zones de ladite pluralité de zones de surface de dépôt est limitée à des dimensions telles que le silicium forme sur chaque zone de ladite pluralité de zones de surface de dépôt dans lesdites conditions de dépôt choisies un seul germe cristallin de dimensions supracritiques qui se développe en un monocristal de silicium ;
iii) le dépôt de ce silicium est effectué par les étapes consistant :

-   à introduire un silane en chaîne ou silane cyclique dont les atomes d'hydrogène sont remplacés partiellement ou totalement par des atomes d'halogènes dans une première chambre d'activation, à former une première entité activée dans ladite première chambre d'activation à partir dudit silane en chaîne ou silane cyclique au moyen d'une énergie d'activation ;
-   à introduire de l'hydrogène gazeux et/ou un halogène gazeux dans une seconde chambre d'activation distincte, à former une seconde entité activée dans ladite seconde chambre d'activation distincte à partir dudit hydrogène gazeux et/ou halogène gazeux au moyen d'une énergie d'activation ; puis
-   à introduire lesdites première et seconde entités activées provenant desdites première et seconde chambres d'activation dans une chambre réactionnelle contenant ledit substrat, ce qui fait que lesdites première et seconde entités activées viennent en contact chimique pour produire une pluralité de précurseurs excités dont au moins un constitue la source de silicium pour lesdits monocristaux de silicium.

2. Procédé suivant la revendication 1, dans lequel l'halogène gazeux consiste en fluor gazeux.

3. Procédé suivant la revendication 1, dans lequel l'halogène gazeux consiste en chlore gazeux.

4. Procédé suivant l'une quelconque des revendications précédentes, dans lequel un composé choisi entre $PH_3$, $P_2H_4$, $PF_3$, $PF_5$, $PCl_3$, $A_sH_3$, $A_sF_3$, $A_sF_5$, $A_sCl_3$, $SbH_3$, $SbF_5$, $BiH_3$, $BF_3$, $BCl_3$, $BBr_3$, $B_2H_6$, $B_4H_{10}$, $B_5H_{11}$, $B_6H_{10}$, $B_6H_{12}$ et $AlCl_3$ est introduit, à l'état gazeux, directement dans la chambre réactionnelle, pour doper le silicium déposé avec une impureté.

5. Procédé suivant l'une quelconque des revendications 1 à 3 précédentes, dans lequel un composé choisi entre $PH_3$, $P_2H_4$, $PF_3$, $PF_5$, $PCl_3$, $A_sH_3$, $A_sF_3$, $A_sF_5$, $A_sCl_3$, $SbH_3$, $SbF_5$, $BiH_3$, $BF_3$, $BCl_3$, $BBr_3$, $B_2H_6$, $B_4H_{10}$, $B_5H_{11}$, $B_6H_{10}$, $B_6H_{12}$ et $AlCl_3$ est activé dans l'une desdites première et seconde chambres d'activation ou, par ailleurs, dans une troisième chambre d'activation, et est ensuite introduit dans la chambre réactionnelle, pour doper avec une impureté le silicium déposé.

6. Procédé suivant l'une quelconque des revendications précédentes, dans lequel la pluralité de zones de surface de dépôt est constituée d'une matière amorphe.

7. Procédé suivant l'une quelconque des revendications précédentes, dans lequel la zone de surface de dépôt adjacente est constituée d'oxyde de silicium et la pluralité de zones de surface de dépôt est constituée de nitrure de silicium.

8. Procédé suivant l'une quelconque des revendications 1 à 6 précédentes, dans lequel la zone de surface de dépôt adjacente est constituée de dioxyde de silicium et la pluralité de zones de surface de dépôt est constituée de zones de dioxyde de silicium ayant subi une implantation avec des ions choisis entre Si, N, P, B, F, Ar, He, C, As, Ga et Ge.

9. Procédé suivant la revendication 1, dans lequel la zone de surface de dépôt adjacente est une surface d'un substrat isolant amorphe et la pluralité de zones de surface de dépôt est constituée d'une matière différente de la matière de la zone de surface de dépôt adjacente, et ladite pluralité de zones de surface de dépôt est disposée sur ladite zone de surface de dépôt adjacente.

10. Procédé suivant la revendication 1, dans lequel la zone de surface de dépôt adjacente est une surface d'un film mince et la pluralité de zones de surface de dépôt est constituée d'une matière différente de la matière de ladite zone de surface de dépôt adjacente, et ladite pluralité de zones de surface de dépôt est disposée sur ladite zone de surface de dépôt adjacente.

11. Procédé suivant la revendication 1, dans lequel la zone de surface de dépôt adjacente est une surface d'un substrat isolant amorphe comportant des évidements et la pluralité de zones de surface de dépôt est constituée d'une matière différente de la matière de ladite zone de surface de dépôt adjacente, et une zone de ladite pluralité de zones de surface de dépôt est présente sur la surface de la base d'une zone respective de chacun des évidements.

12. Procédé suivant la revendication 1, dans lequel la zone de surface de dépôt adjacente est une surface d'un film mince comportant des évidements, film mince qui est présent sur la surface d'un substrat, et la pluralité de zones de surface de dépôt est constituée d'une matière différente de la matière de ladite zone de surface de dépôt adjacente et une zone de ladite pluralité de zones de surface de dépôt est présente sur la surface de la base d'une zone respective de chacun des évidements.

13. Procédé suivant la revendication 1, dans lequel la zone de surface de dépôt adjacente est une surface d'un film mince, film mince qui est présent sur une surface d'un substrat comportant des évidements, et une zone de ladite pluralité de zones de surface de dépôt est présente sur ladite zone de surface de dépôt adjacente à la base d'une zone respective de chacun des évidements.

14. Procédé suivant la revendication 1, dans lequel la zone de surface de dépôt adjacente est une surface d'un premier film mince présent sur un second film mince isolant amorphe constitué d'une matière différente de la matière de ladite zone de surface de dépôt adjacente, et ladite pluralité de zones de surface de dépôt est constituée de zones respectives de la surface dudit second film mince isolant amorphe exposée au niveau d'orifices dudit premier film mince.

**15.** Procédé suivant la revendication 1, dans lequel le substrat est constitué d'un substrat de base, d'un premier film mince sur la surface dudit substrat de base, d'un deuxième film mince sur la surface du premier film mince, d'un troisième film mince sur la surface du deuxième film mince, ledit troisième film étant présent avec une pluralité d'évidements exposant des zones respectives dudit deuxième film mince, ledit deuxième film mince comportant des orifices respectifs à la base de chaque évidement respectif exposant des zones respectives dudit premier film mince, ladite zone de surface de dépôt adjacente étant la surface exposée desdits deuxième et troisième films minces, ladite pluralité de zones de surface de dépôt consistant en lesdites zones du premier film mince exposé, et ledit troisième film mince ayant, dans des conditions de dépôt choisies, une propriété de nucléation de silicium à une densité de nucléation égale ou inférieure à celle dudit deuxième film mince.

**16.** Procédé suivant l'une quelconque des revendications 9, 10 et 14, dans lequel la croissance d'un monocristal à partir de chaque germe cristallin unique s'effectue jusqu'à ce que les monocristaux adjacents entrent en contact les uns avec les autres.

**17.** Procédé suivant la revendication 16, dans lequel les surfaces des monocristaux sont aplaties par attaque ou polissage.

**18.** Procédé suivant la revendication 17, dans lequel les limites des grains formées entre les monocristaux sont éliminées.

# Fig.1

# Fig. 2

(A)

(B)

# *Fig. 3*

# Fig. 4

## (A)

12-2　　　　　　　　　　　　12-1

ℓ

11

## (B)

13-2　　　　　　　　　　　13-1

11

## (C)

13A-2　　　　14　　　　13A-1

$\frac{ℓ}{2}$

11

## (D)

15-2　　　　　　　　　　15-1

## Fig. 5

(A)

(B)

# *Fig. 6*

(A)

(B)

(C)

(D)

# Fig.7

(A)

(B)

(C)

# Fig.8

## (A)

## (B)

# Fig.9

(A)

(B)

(C)

# Fig. 10

(A)

(B)

(C)

# Fig. II

## (A)

## (B)

## (C)

## (D)

# Fig. 12

# Fig. 13

# Fig. 14

# *Fig.15*

## (A)

## (B)

## (C)

## (D)

## Fig. 16

### (A)

### (B)

# Fig. 17

(A)

(B)

(C)

# Fig. 18

## (A)

14-2    12A-1

10

## (B)

15-1

10

# Fig. 19

## (A)

## (B)

## (C)

## (D)

# Fig. 20

# Fig. 22

# Fig. 23

## Fig. 21

(A) — 206

(B) — 207
— 206

(C) — 208
— 207
— 206

(D) 2o8A
209
208
207 } 118
206

(E) 210
204
209
208
207
206

41